(19) Europäisches Patentamt
European Patent Office
Office européen des brevets

(11) EP 1 595 155 B1

(12) **EUROPÄISCHE PATENTSCHRIFT**

(45) Veröffentlichungstag und Bekanntmachung des Hinweises auf die Patenterteilung:
**30.11.2011 Patentblatt 2011/48**

(21) Anmeldenummer: **04707867.0**

(22) Anmeldetag: **04.02.2004**

(51) Int Cl.:
***G01R 31/3167*** *(2006.01)* ***G01R 31/3187*** *(2006.01)*

(86) Internationale Anmeldenummer:
**PCT/DE2004/000175**

(87) Internationale Veröffentlichungsnummer:
**WO 2004/077083 (10.09.2004 Gazette 2004/37)**

(54) **VORRICHTUNG SOWIE VERFAHREN ZUR TOLERANZANALYSE VON DIGITALEN UND/ODER DIGITALISIERTEN MESSWERTEN**

DEVICE AND METHOD FOR THE TOLERANCE ANALYSIS OF DIGITAL AND/OR DIGITALISED MEASURING VALUES

DISPOSITIF ET PROCEDE POUR ANALYSER LES TOLERANCES DE VALEURS DE MESURE NUMERIQUES ET/OU NUMERISEES

(84) Benannte Vertragsstaaten:
**DE**

(30) Priorität: **21.02.2003 DE 10307690**

(43) Veröffentlichungstag der Anmeldung:
**16.11.2005 Patentblatt 2005/46**

(73) Patentinhaber: **Infineon Technologies AG**
**85579 Neubiberg (DE)**

(72) Erfinder:
- **OBERLE, Hans-Dieter**
**82178 Puchheim (DE)**
- **SATTLER, Sebastian**
**81541 München (DE)**

(74) Vertreter: **Schäfer, Horst**
**Schweiger & Partner**
**Patent- und Rechtsanwälte**
**Karlstrasse 35**
**80333 München (DE)**

(56) Entgegenhaltungen:
**EP-A- 0 042 878**
**WO-A-02/14883**
**DE-A- 19 705 406**
**US-A- 4 791 357**
**US-A1- 2002 019 962**

- **PATENT ABSTRACTS OF JAPAN vol. 005, no. 185 (P-091), 25. November 1981 (1981-11-25) -& JP 56 114037 A (TOSHIBA CORP), 8. September 1981 (1981-09-08)**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft eine Vorrichtung sowie ein Verfahren zur Toleranzanalyse von digitalen und/oder digitalisierten Messwerten.

Integrierte elektrische Schaltungen liefern abhängig von an ihren Eingängen angelegten digitalen und/oder digitalisierten Eingangswerten bestimmte Ausgangswerte. Von diesen Ausgangswerten hängt die Brauchbarkeit der integrierten elektrischen Schaltungen ab. Diese Ausgangswerte werden daher häufig durch Toleranzanalysen überprüft.

Solche Toleranzanalysen werden häufig an externen Messgeräten oder an sogenannten Testern durchgeführt. Die untersuchten Ausgangswerte werden dabei an den I/O-Pins der integrierten elektrischen Schaltungen abgegriffen.

Die JP 56114037 zeigt eine Vorrichtung, die über eine Vergleichseinheit verfügt, mit der digitalisierte Werte mit einem vorgegebenen Wert verglichen werden können, um zu überprüfen, ob der Messwert in einem vorgeschriebenen Bereich liegt.

Die WO 02/14883 zeigt eine Schaltung, bei der analoge Signale überprüft werden, ob sie innerhalb eines bestimmten Bereichs liegen.

In der 2002/0019962 wird ein digitalisiertes Signal gemessen, indem gezählt wird, wie oft es eine bestimmte Schaltschwelle überschreitet.

Es ist daher Aufgabe der Erfindung, eine kostengünstige Vorrichtung zur Toleranzanalyse von digitalen und/oder digitalisierten Messwerten anzugeben, bei der Selbsttests von integrierten elektrischen Schaltungen durchgeführt werden können. Es ist eine weitere Aufgabe der Erfindung, ein schnell durchführbares Verfahren zur Toleranzanalyse von digitalen und/oder digitalisierten Messwerten anzugeben, das auch für einen solchen Selbsttest anwendbar ist.

Diese Aufgaben werden durch den Gegenstand der unabhängigen Ansprüche 1,2 und 15 gelöst. Vorteilhafte Ausgestaltungen ergeben sich aus den jeweiligen Unteransprüchen.

Die Erfindung betrifft eine elektrische Toleranzanalyseschaltung, mit der digitale .und digitalisierte Messwerte anhand wenigstens eines vorgebbaren Toleranzkriteriums überprüft werden können. Diese elektrische Toleranzanalyseschaltung umfasst dabei Eingänge zum Empfang eines n-bit-wertigen Messwerts, eines n-bit-wertigen Referenzwerts und eines (m+1)-bit-wertigen Toleranzwerts. Die elektrische Toleranzanalyseschaltung verfügt über eine Überprüfungseinrichtung zum Überprüfen des Messwerts sowie über eine Ausgabeeinrichtung zur Ausgabe eines Ausgangswerts. Die Ausgabeeinrichtung kann beispielsweise in Form einer Leitung oder einer Datenleitung, in Form eines Displays oder in Form einer Lampe ausgebildet sein. Der Ausgangswert ergibt sich aus dem Zustand der Überprüfungseinrichtung und trifft eine Aussage darüber, ob der jeweils betrachtete Messwert das jeweils vorgegebene Toleranzkriterium erfüllt oder nicht. Die Überprüfung des Messwerts auf das jeweils vorgegebene Toleranzkriterium erfolgt dabei in der Überprüfungseinrichtung.

Der Umfang der von der elektrischen Toleranzanalyseschaltung erzeugten Ausgangswerte kann relativ gering gehalten werden, wenn der Ausgangswert nur 1-bit-wertig ausgebildet ist. Dabei nimmt der Ausgangswert vorteilhafterweise einen Wert 0 an, wenn der jeweils betrachtete Messwert das jeweils vorgegebene Toleranzkriterium nicht erfüllt und einen Wert 1 an, wenn der jeweils betrachtete Messwert das jeweils vorgegebene Toleranzkriterium erfüllt. Ein derart ausgebildeter Ausgangswert bildet ein zuverlässiges Testergebnis des jeweils betrachteten Messwerts und trifft eine dem jeweils betrachteten Messwert eindeutig zugeordnete Aussage Pass/Fail bzw. Go/No-Go über die Qualität des Messwerts.

Mit einer solchen Toleranzanalyseschaltung können eine Vielzahl von Messwerten anhand von jeweils zuordenbaren Referenzwerten und Toleranzwerten sehr effektiv und zuverlässig überprüft werden. Solch eine Toleranzanalyseschaltung eignet sich nicht nur für eine Überprüfung an externen Messgeräten, sondern auch für Tests im Betrieb sowie für Selbsttests von elektrischen und elektronischen Schaltkreisen.

Gemäß einer ersten Ausführungsform der Toleranzanalyseschaltung sind für die in der Überprüfungseinrichtung vorzunehmende Überprüfung des Messwerts zwei verschiedene Modi denkbar, nämlich der Diagnose- bzw. Toleranzanalysemodus sowie der Produktionstestmodus. Bei dem Diagnosemodus wird der Messwert $x_p$ auf das Erfüllen der Gleichung

$$\left(x_p - x_i\right) = \Delta x_q \qquad (1),$$

bei dem Produktionstestmodus auf das Erfüllen der Gleichung

$$\left|x_p - x_i\right| \leq \Delta x_i \qquad (2)$$

hin getestet. Dabei stellen $x_i$ einen vorgebbaren Referenzwert und $\Delta x_q$ einen vorgebbaren Toleranzwert dar.

Die Überprüfung durch die Toleranzanalyseschaltung gestaltet sich durch diese einfach abzuprüfenden Toleranzkriterien sehr transparent und kann darüber hinaus sehr schnell und sogar at-speed im Betrieb eines mit der Toleranzanalyseschaltung verbundenen Schaltkreises durchgeführt werden.

Die erfindungsgemäße elektrische Toleranzanalyseschaltung weist eine breite Palette von Realisierungsmöglichkeiten auf.

In einer Ausführung der Erfindung umfasst die Überprüfungseinrichtung der Toleranzanalyseschaltung einen Subtrahierer sowie einen mit dem Subtrahierer verbundenen Toleranzfilter. Der Subtrahierer verfügt über Eingänge zum Empfang des Messwerts und des Referenzwerts und erzeugt aus diesen beiden Werten einen Differenzwert. Der Toleranzfilter hat Eingänge zum Empfang des Toleranzwerts und des Differenzwerts und erzeugt,den Ausgangswert unter Verwendung des Toleranzwerts und des Differenzwerts.

Der Subtrahierer kann in einer solchen Überprüfungseinrichtung auch als Komplementaddierer mit einem invertierenden Eingang zum Empfang des Referenzwerts ausgebildet sein. Dieser Komplementaddierer erzeugt einen Additionswert aus dem empfangenen Messwert sowie aus dem Einserkomplement oder aus dem Zweierkomplement des Referenzwerts und überträgt diesen Additionswert an den Toleranzfilter. Der Toleranzfilter erzeugt den Ausgangswert dabei unter Verwendung des Toleranzwerts und des vom Komplementaddierer bereitgestellten Additionswerts. Gemäß einem Grundgedanken der Erfindung kann auf diese Weise jede Messung auf einen Referenzwert bezogen werden und die Toleranz mit Hilfe einer einfachen Logik ausgewertet werden. Der Additionswert aus dem Messwert und aus dem Einserkomplement des Referenzwerts ist dabei mit großer Wahrscheinlichkeit in dem Binärzahlenbereich des Toleranzbandes angesiedelt. Die mathematischen Berechnungen in diesem Toleranzband können mit relativ geringem Rechenaufwand durchgeführt werden, zumal die mittleren und vorderen Bits der betrachteten Binärzahlenwerte in diesem Referenzband jeweils fast identische Bitkombinationen aufweisen.

Eine weitere Ausführungsform der Erfindung besteht darin, dass eine Modusauswahlvariable vorgesehen ist, die von außen an einen weiteren Eingang der Toleranzanalyseschaltung, insbesondere des Toleranzfilters angelegt werden kann. Mittels dieser Modusauswahlvariable kann für jeden Messwert individuell festgelegt werden, ob seine Überprüfung mittels des Toleranzkriteriums der Gleichung (1) oder mittels des Toleranzkriteriums der Gleichung (2) erfolgt. Eine solche Toleranzanalyseschaltung bietet dem Benutzer eine besonders hohe Funktionalität und einen großen Anwendungsbereich.

Gemäß einer einfach zu realisierenden und präzise arbeitenden Realisierung der Toleranzanalyseschaltung weist der Toleranzfilter einen Grobfilter, einen Feinfilter und ein Merkerregister (Flag-Register) auf. Dabei ist der Eingang des Grobfilters mit dem Ausgang des Subtrahierers bzw. des Komplementaddierers verbunden. Die Eingänge des Feinfilters sind mit dem Ausgang des Subtrahierers bzw. des Komplementaddierers, mit dem Ausgang des Grobfilters, mit einer Datenleitung zum Empfangen des Toleranzwerts und/oder des Referenzwerts und optional mit einer Datenleitung zum Empfangen der Modusauswahlvariable verbunden. Ein Eingang des Flag-Registers ist mit dem Ausgang des Feinfilters verbunden. Des weiteren kann ein weiterer Eingang des Flag-Registers mit einer Datenleitung zum Empfangen der Modusauswahlvariable verbunden sein. Der Ausgangswert wird dabei vom Ausgang des Flag-Registers an die Ausgabeeinrichtung ausgesendet. Eine derartige Realisierung des Toleranzfilters ist besonders rechenzeitoptimal und relativ einfach umsetzbar.

Gemäß einer weiteren Ausführungsform der Erfindung weist der Grobfilter ein NAND-Gatter und ein Oder-Gatter auf. Dabei verarbeitet der Grobfilter die (n+1-m)-vorderen Bits des vom Subtrahierer erzeugten Differenzwerts bzw. des vom Komplementaddierer erzeugten Additionswerts und erzeugt eine insbesondere 2-bit-wertige Ausgabe, die angibt, ob der Messwert oberhalb oder unterhalb des Referenzwerts liegt.

Diese besonders einfache schaltungstechnische Realisierung des Grobfilters nacht sich die Erkenntnis zunutze, dass der erzeugte Additionswert nahe einem aus der Summe des Referenzwerts und des Einserkomplement des Referenzwerts gebildeten Wert liegt und dass diese beiden Werte in ihrem vorderen und mittleren Bereich jeweils einfach zu vergleichende, idealerweise nahezu identische Bitfolgen aufweisen.

Gemäß einer Ausführungsform der Erfindung werden dem Feinfilter nur die m-hinteren Bits (LSBs bzw. Least Significant Bits) vom Differenzwert bzw. vom Additionswert zugeleitet. Der Feinfilter ist dabei so ausgebildet, dass er eine insbesondere 1-bit-wertige Messantwort erzeugt, die angibt, ob der betrachtete Messwert dem jeweils gewählten Toleranzkriterium genügt. Diese Messantwort trifft eine zuverlässige Aussage über die Qualität des Messwerts.

Eine schaltungstechnisch besonders einfache Ausgestaltung des Merkerregisters umfasst drei AND-Gatter sowie ein Oder-Gatter. Im Diagnosemodus leitet das Merkerregister die Messantwort ohne Änderung an die Ausgabeeinrichtung weiter. Im Produktionstestmodus leitet das Merkerregister die Messantworten nur solange unverändert weiter, bis es eine Messantwort registriert, die anzeigt, dass der aktuell betrachtete Messwert das betrachtete Toleranzkriterium nicht erfüllt. Solch eine Messantwort ist in der Praxis vorzugsweise als ein Wert Null realisiert. Ab dem Erfassen einer solchen Messantwort setzt das Merkerregister die Ausgabeeinrichtung und somit den Ausgabewert dauerhaft auf Null. Somit wird im Produktionstestmodus schon ein einmaliges Nicht-Erfüllen des Toleranzkriteriums gespeichert. Dies ist im Diagnosemodus nicht vorgesehen.

Eine mit einem solchen Merkerregister ausgestattete Toleranzanalyseschaltung kann somit zuverlässig sowohl im Entwicklungsprozess als auch in der Produktion oder zum Funktionstest angewendet werden.

Die Erfindung betrifft auch eine Toleranzanalyseanordnung, die eine vorstehend beschriebene elektrische Toleranzanalyseschaltung, einen Test-Schaltkreis zum Empfang und zum Verarbeiten von Teststimuli und zum Erzeugen von Messwerten sowie eine Speichereinheit aufweist. Eine Datenleitung zum Übertragen von Messwerten verbindet den Ausgang des Test-Schaltkreises mit einem Eingang der elektrischen Toleranzanalyseschaltung, insbesondere mit einem Eingang des Subtrahierers oder des Komplementaddierers. Eine weitere Datenleitung zum Übertragen von Referenz- und Toleranzwerten verbindet wenigstens einen Ausgang der Speichereinheit mit wenigstens einem Eingang der elektrischen Toleranzanalyseschaltung, insbesondere mit dem Subtrahierer bzw. Komplementaddierer und mit dem Feinfilter. Ein Eingang des Test-Schaltkreises sowie ein Eingang der Speichereinheit nehmen synchron nacheinander eine Anzahl von Teststimuli auf. Die Speichereinheit ordnet dabei jedem Teststimulus wenigstens einen Referenzwert und wenigstens einen Toleranzwert zu.

Dabei kann über die Wahl der Laufvariablen für den Teststimulus, für den Referenzwert und für den Toleranzwert eingestellt werden, ob jedem Teststimulus je ein oder mehrere Referenz- und Toleranzwerte zugeordnet werden. Die Teststimuli werden dabei von einem externen Gerät, insbesondere von einem Testgenerator, erzeugt und an den Test-Schaltkreis sowie an die Speichereinheit angelegt.

Gemäß einem weiteren Grundgedanken der Erfindung sind bei Anwendung einer solchen Toleranzanalyseanordnung außer einem externen Testgenerator keine weiteren externen Messgeräte nötig.

Ein weiterer Vorteil dieser Toleranzanalyseanordnung besteht darin, dass für das Durchführen von solchen Toleranzanalysen keine zusätzlichen Pins bei den Test-Schaltkreisen freigeschaltet werden müssen, sondern die normalen zur Ein- und Ausgabe der Betriebsdaten bereitstehenden Pins verwendet werden können. Durch eine solche Toleranzanalyseanordnung ist erstmals eine Toleranzanalyse mittels eines Selbsttests sowie mittels eines Tests at-speed möglich.

In einer Ausführungsform der erfindungsgemäßen Toleranzanalyseanordnung umfasst die Speichereinheit ferner einen Zähler, der durch eine weitere Datenleitung mit der Ausgabeeinrichtung der elektrischen Toleranzanalyseschaltung verbunden ist. Dabei ordnet der Zähler den in der Speichereinheit abgelegten Referenzwerten und Toleranzwerten Zählerstände in Abhängigkeit von den erzeugten Ausgangswerten zu und inkrementiert diese Zählerstände jeweils um den Betrag des betreffenden Ausgangswerts.

Dadurch wird sichergestellt, dass nach einer Abarbeitung einer Reihe von Teststimuli genau festgestellt werden kann, welche Teststimuli bei welchen Referenz- und Toleranzwerten zu korrekten oder zu nicht korrekten Ergebnissen geführt haben. Dieser Zähler wird dabei insbesondere beim Diagnosemodus angewendet. Beim Produktionstestmodus kann auf das Vorsehen oder auf die Inbetriebnahme eines solchen Zählers verzichtet werden.

Gemäß einer vorteilhaften Weiterbildung der Speichereinheit umfasst die Speichereinheit eine Referenzwertdatenbank, die verschiedenen Teststimuli jeweils wenigstens einen Referenzwert und jeweils wenigstens einen Toleranzwert zuweist. In einer solchen Referenzwertdatenbank können eine Vielzahl von Referenz- und Toleranzwerten gespeichert und kombiniert sowie jeweils bestimmten Teststimuli zugeordnet werden. Bestehende Kombinationen dieser Werte können leicht von anderen Speichermedien überspielt werden. Das Erweitern und Ändern von solchen Referenzwertdatenbanken ist ebenfalls leicht möglich.

Die Erfindung betrifft auch einen Halbleiterchip bzw. einen IC, auf dem eine vorstehend beschriebene Toleranzanalyseschaltung enthalten ist. Diese Toleranzanalyseschaltung ist dabei insbesondere zusätzlich zur normalen Schaltung als add-on vorgesehen. Die Erfindung betrifft auch eine Nadelkarte zum Testen von Halbleiterchips bzw. von ICs, bei der eine vorstehend beschriebene elektrische Toleranzanalyseschaltung integriert ist. Die Erfindung betrifft weiterhin ein testerspezifisches Loadboard mit Testfassungen zum Einstecken von Halbleiterchips bzw. ICs oder zur Aufnahme einer solchen Nadelkarte oder zum Anschluß eines Handlers, wobei auf dem Loadboard eine solche elektrische Toleranzanalyseschaltung integriert ist. Ein solches Loadboard kann auch als Adapterboard bezeichnet werden.

Die Erfindung betrifft ferner ein Messgerät bzw. einen Tester mit Mess-Sensoren z.B. für Ströme und für Spannungen und mit Instrumenten zur Erzeugung von digitalen, zur Weiterverarbeitung mit einem mit dem Messgerät verbundenen Computersystem bestimmten Signalen aus den gemessenen Strömen und Spannungen. Dabei ist auf dem Messgerät eine vorstehend beschriebene elektrische Toleranzanalyseschaltung enthalten.

Gemäß einem weiteren Grundgedanken der Erfindung kann die erfindungsgemäße elektrische Toleranzanalyseschaltung auch mit einer solchen Speichereinheit einfach und sehr platzsparend auf allen möglichen Schaltungen oder Geräten in jeder Abstraktionsebene bzw. auf jeder Messgeräteebene vorgesehen werden. Beeinträchtigungen der Funktionsweise ergeben sich dabei nicht.

Dabei ist lediglich zu beachten, dass die elektrische Toleranzanalyseschaltung jeweils zusätzlich zu den auf den vorstehend genannten Gegenständen enthaltenen Schaltungen aufzubringen ist.

Die Erfindung kann für eine allgemeine Toleranzmessung, für einen Augendiagramm-Test, für eine Data Dependent Jitter Analyse, für einen ADC-Test, für einen Random Jitter-Test, für einen Deterministic Jitter-Test, für einen DAC-ADC-Test oder für einen Pseudo Random Bit-Test verwendet werden.

Die Erfindung betrifft auch ein Verfahren zur Toleranzanalyse nach dem Anspruch 15. Es wird zunächst eine vorstehend beschriebene Toleranzanalyseanordnung sowie ein Teststimulus-Generator vorgesehen. Dabei ist die Toleranzanalyseanordnung, insbesondere die entsprechenden Eingänge des Test-Schaltkreises und des Speicherbereichs, mit einem Ausgang des Teststimulus-Generators verbunden.

Bei diesem Verfahren wird zunächst ein digitaler oder digitalisierter Teststimulus durch den Teststimulus-Generator erzeugt und danach synchron an die Testschaltungen und an den Speicherbereich angelegt. Anschließend werden ein Messwert durch Verarbeiten des Teststimulus durch die Testschaltung erzeugt und dieser Messwert an die elektrische Toleranzanalyseschaltung angelegt. Im wesentlichen parallel dazu wird dem Teststimulus wenigstens ein Referenzwert und wenigstens ein Toleranzwert durch die Referenzwertdatenbank des Speicherbereichs zugeordnet. Dieser Toleranzwert bzw. diese Toleranzwerte und dieser Referenzwert bzw. diese Referenzwerte werden dann an die elektrische Toleranzanalyseschaltung angelegt. Bei einer Toleranzanalyseanordnung, die keine Modusauswahlvariable vorsieht, wird dabei das voreingestellte Toleranzkriterium überprüft.

Die Überprüfungseinrichtung der Toleranzanalyseschaltung erzeugt daraufhin einen Ausgangswert durch Überprüfen des Messwerts auf das entsprechende Toleranzkriterium gemäß einer der Gleichungen (1) oder (2). Dieser Ausgangswert wird am Ausgang der elektrischen Toleranzanalyseschaltung durch die Ausgabeeinrichtung für eine weitere Verarbeitung bereitgestellt.

Die Verfahrensschritte, beginnend mit dem Verfahrensschritt des Erzeugen eines digitalen oder digitalisierten Teststimulus durch den Teststimulusgenerator, werden dabei so oft wiederholt, bis die gewünschte, von dem Teststimulus-Generator erzeugte und/oder von dem Benutzer vorgegebene Anzahl der Teststimuli abgearbeitet worden ist.

Ein derartiges Toleranzanalyseverfahren kann gemäß einem weiteren Grundgedanken der Erfindung on chip oder on Loadboard durchgeführt werden, ohne dass externe Messgeräte benötigt werden. Auch ein Selbsttest zur Diagnose im Feld ist dabei möglich. Das erfindungsgemäße Verfahren weist dabei einen sehr einfachen und gut implementierbaren Ablauf auf und kann demzufolge zur Toleranzanalyse von beinahe beliebig komplexen Schaltkreisen eingesetzt werden. Gemäß dem Verfahren ist eine Modusauswahlvariable vorgesehen. Bei einer solchen Toleranzanalyseanordnung wird ein Wert für diese Modusauswahlvariable zu Beginn des Verfahrens oder bei der Erzeugung der Teststimuli durch den Teststimulus-Generator vorgegeben. Danach wird das mittels dieser Modusauswahlvariable ausgewählte Toleranzkriterium überprüft. Ein derartiges Verfahren stellt dem Benutzer eine zusätzliche Funktionalität zur Verfügung und versetzt ihn in die Lage, jeweils den für seine aktuellen Bedürfnisse geeigneten Verfahrensmodus auswählen zu können.

In einer weiteren Ausführungsform dieses Toleranzanalyseverfahrens leitet die Ausgabeeinrichtung den Ausgangswert dem Zähler zu, der den Ausgangswert einem Zählerwert des jeweils betrachteten Referenz- und Toleranzwerts zuordnet und diesen Zählerwert schließlich um den Betrag des Ausgangswerts inkrementiert. Diese Verfahrensvariante wird dabei insbesondere für den Diagnosemodus gewählt. Dadurch lässt sich auch nach der Abarbeitung eine Vielzahl von Teststimuli zuverlässig feststellen, bei welchen Teststimuli Fehler detektiert worden sind und bei welchen nicht.

Ein Computerprogramm kann zum Ausführen des Verfahrens zur Toleranzanalyse von digitalen und/oder digitalisierten Messwerten eingesetzt werden.

Das Computerprogramm enthält dabei Programmanweisungen, die ein Computersystem veranlassen, solche Verfahren in einer vorstehend beschriebenen Ausführungsform auszuführen. Dabei werden insbesondere die Verfahrensschritte, beginnend mit dem Verfahrensschritt des Erzeugens eines digitalen oder digitalisierten Teststimulus durch den Teststimulusgenerator auf einem Computersystem durchgeführt.

Das Computerprogramm gibt als Ergebnis die Ausgabewerte auf einer Ausgabeeinheit aus, insbesondere auf einem Bildschirm oder auf einem Drucker. Basierend auf diesen Ausgabewerten können, insbesondere falls der Diagnosemodus gewählt worden ist, ggf. Verbesserungen an dem Test-Schaltkreis vorgenommen werden. Falls der Produktionstestmodus gewählt worden ist, so kann eine zuverlässige Pass/Fail-Aussage über die Funktionalität des Test-Schaltkreises getroffen werden. Durch das Computerprogramm können elektrische und elektronische Bauteile beinahe beliebiger Komplexität schnell, effektiv und zuverlässig getestet werden.

Das Computerprogramm kann auf einem Speichermedium enthalten, in einem Computerspeicher abgelegt, in einem Nur-Lese-Speicher bzw. in einem ROM-Speicher enthalten sein oder sein auf einem elektrischen Trägersignal übertragen werden. Auch auf einem Trägermedium, insbesondere einem Datenträger, wie bspw. einer Diskette, einem Zip-Laufwerk, einem Streamer, einer CD oder einer DVD, kann ein vorstehend beschriebenes Computerprogramm abgelegt sein. Ferner kann auf einem Computersystem ein solches Computerprogramm gespeichert sein. Schließlich kann ein solches Computerprogramm aus einem elektronischen Datennetz, wie bspw. aus dem Internet auf einen an das Datennetz angeschlossenen Computer heruntergeladen werden.

Die Erfindung ist in den Zeichnungen anhand eines Ausführungsbeispiels näher veranschaulicht.

Figur 1 zeigt eine Zahlenstrahldarstellung sowie eine Häufigkeitsverteilung eines Messwerts jeweils im Verhältnis zu einem Referenzwert,

Figur 2 zeigt eine Zahlenbereichsdarstellung für ein Ausführungsbeispiel mit einem Messwert, mit einem Referenzwert und mit einem Toleranzwert,

Figur 3 zeigt ein Prinzipschaltbild einer ersten Toleranzanalyseschaltung mit einem Subtrahierer und mit einem Toleranzfilter,

Figur 4 zeigt ein weiteres Prinzipschaltbild der ersten Toleranzanalyseschaltung mit einem höheren Detaillierungsgrad,

Figur 5 zeigt eine Grobfilter-Gatterdarstellung des Grobfilters aus Figur **4**,

Figur 6 zeigt eine Merkerregister-Gatterdarstellung sowie eine zugehörige Merkerregister-Wahrheitstabelle des Merkerregisters aus Figur **4**,

Figur 7 zeigt eine Feinfilter-Blackboxdarstellung des Feinfilters aus Figur **4**,

Figur 8 zeigt eine dem in den Figuren 4 und 7 gezeigten Feinfilter zugrundeliegende Feinfilter-Wahrheitstabelle,

Figur 9 zeigt eine Toleranzanalyseanordnung mit der in Figur 4 gezeigten ersten Toleranzanalyseschaltung, mit einem Test-Schaltkreis sowie mit einem Speicherbereich,

Figur 10 zeigt eine andere Toleranzanalyseanordnung.

Figur 1 zeigt eine Zahlenstrahldarstellung 1 sowie eine Häufigkeitsverteilung 2 eines Messwerts $x_p \geq 0$ jeweils im Verhältnis zu einem Referenzwert $x_i \geq 0$.

Der Messwert $x_p$ ist digital oder digitalisiert und soll gemäß einer Benutzervorgabe in einem definierten Toleranzbereich

$$\left|x_p - x_i\right| \leq \Delta x_i$$

liegen. Dabei stellt $\Delta x_q$ eine dazugehörige, durch einen Benutzer vorgebbare Toleranz dar. Die Zahlenstrahldarstellung 1 zeigt den Referenzwert $x_i$ sowie den Messwert $x_p$ durch zwei übereinander angeordnete Zahlenstrahlen. Der Toleranzbereich $[x_i - \Delta x_q; x_i + \Delta x_q]$ ist mittels zwei knapp oberhalb des rechten Endes des unteren Zahlenstrahls ansetzenden Zahlenstrahlabschnitten - $\Delta x_q$ und + $\Delta x_q$ dargestellt. Aus Figur 1 ist ersichtlich, dass der Messwert $x_p$ größer als der vorgegebene Referenzwert $x_i$ ausgebildet ist und innerhalb des definierten Toleranzbereichs $[x_i - \Delta x_q; x_i + \Delta x_q]$ liegt.

Durch einen zusätzlichen Offset kann gewährleistet werden, das die Werte $x_p$; $x_i$ immer positiv ausgebildet sind.

Die Wahrscheinlichkeitsverteilung 2 zeigt die Messwerte $x_p$ um den Referenzwert bzw. Sollwert $x_i$ gruppiert. Der Toleranzbereich $|x_p - x_i|$ ist durch den Toleranzwert $\Delta x_q$ festgelegt und definiert die Häufigkeit für das Auftreten eines Messwerts $x_p$ in dem in Figur 1 schraffiert dargestellten Bereich. Dabei können Tripel ($x_p$; $x_i$ ; $\Delta x_q$) gebildet werden, um den Messwerten $x_p$ Referenzwerte $x_i$ und Toleranzwerte $\Delta x_q$ zuzuordnen. Die Wahrscheinlichkeitsverteilung 2 stellt eine Wahrscheinlichkeitsverteilung für eine Anzahl von Tripeln ($x_p$ ; $x_i$; $\Delta x_q$) dar, wobei der Referenzwert $x_i$ und die Toleranzwerte $\Delta x_q$ individuell vorgebbar sind und die Messwerte $x_p$ durch eine beliebige Messung bestimmt werden können.

Demnach werden Messwerte $x_p$, die in dem Toleranzbereich $[x_i - \Delta x_q\ x_i + \Delta x_q]$ liegen, als zulässig erachtet, Messwerte $x_p$, die nicht in diesem Toleranzbereich angeordnet sind, sollen erfindungsgemäß zuverlässig festgestellt werden. Dabei stellt die Erfindung einen auch als Toleranzanalysemodus bezeichneten Diagnosemodus sowie einen Produktionstestmodus zur Verfügung.

Bei dem Diagnosemodus wird als Bedingung die Gleichung (1) vorgegeben. Der Referenzwert $x_i$ weist dabei die Laufvariable i auf. Der Toleranzwert $\Delta x_q$ hat dabei die Laufvariable q. Durch das Vorsehen von verschiedenen Laufvariablen i und q für den Referenzwert $x_i$ und für den Toleranzwert $\Delta x_q$ ist es möglich, für einen einzigen Referenzwert $x_i$ eine Vielzahl von Toleranzwerten $\Delta x_q$ bereitzustellen.

Bei dem Produktionstestmodus wird als Bedingung die Gleichung (2) vorgegeben. Der Referenzwert $x_i$ und der Toleranzwert $\Delta x_q = \Delta x_i$ weisen dabei die gleiche Laufvariable i auf. Daher kann für jeden Referenzwert $x_i$ jeweils genau ein Toleranzwert $\Delta x_i$ vorgegeben werden. Bei einem solchen Produktionstest werden alle Messwerte $x_p$ betrachtet und schließlich eine Go/No-Go- bzw. eine Pass/Fail-Entscheidung für das gesamte getestete Bauteil getroffen, von dem die Messwerte $x_p$ erzeugt worden sind.

Das grundlegende Prinzip für die schaltungstechnische Realisierung der Gleichungen (1) und (2) beruht auf der Verwendung des Einserkomplements $\bar{x}_i$ für die Subtraktion von $x_p$ und $x_i$, wie aus der folgenden Gleichung (3) ersichtlich.

$$(x_p - x_i - 1) = (x_p + \bar{x}_i) \quad (3)$$

Damit wird die Differenz $x_p$-$x_i$ in einen Zahlenbereich transformiert, der durch einfach zu decodierende Binärmuster ausgezeichnet ist.

Figur 2 zeigt eine Zahlenbereichsdarstellung 3 für ein Ausführungsbeispiel mit einem Messwert $x_p = (46)_{10} = (101110)_2$, mit einem Referenzwert $x_i = (50)_{10} = (110010)_2$ und mit einem Toleranzwert $\Delta x_q = (7)_{10} = (111)_2$.

Die Zahlenbereichsdarstellung 3 weist insgesamt neun nebeneinander angeordnete Spalten und eine Vielzahl von in Figur 2 untereinander angeordneten Zeilen auf. Die Zahlenbereichsdarstellung 3 stellt dabei von oben nach unten jeweils aufsteigende Zahlen in der ersten Spalte in Dezimaldarstellung und in den weiteren acht Spalten in Binärdarstellung dar. Zeilen mit für die nachfolgende Berechnung nicht relevanten Zahlen sind in Figur 2 jeweils durch Punkte abgekürzt dargestellt.

Bei der Binärdarstellung in den Spalten 2 bis 9 ist eine 8-Bit-Darstellung gewählt. Die erste Spalte der Binärdarstellung zeigt jeweils das höchstwertigste Bit, das auch als MSB bzw. als Most Significant Bit bezeichnet wird. Die letzten drei Spalten repräsentieren jeweils die drei niederwertigsten Bits, die auch als LSBs bzw. als Least Significant Bits bezeichnet werden. Die zwischen dem MSB und den LSBs liegenden Bits werden im vorliegenden Ausführungsbeispiel als $y_k$ bezeichnet.

Das Einserkomplement $\bar{x}_i$ beträgt im vorliegenden Ausführungsbeispiel $\bar{x}_i = (77)_{10} = (1001101)_2$. $(x_p+\bar{x}_i)$ aus Gleichung (3) ergibt sich zu $(123)_{10} = (01111011)_2$. Des weiteren ist der Wert $(x_i+\bar{x}_j)$ von Interesse, der sich zu $(127)_{10} = (01111111)_2$ ergibt. Bei diesem Wert erfolgt nämlich der Bitüberlauf der ersten der acht Binärstellen, d.h. dass das MSB von 0 auf 1 wechselt.

Das beschriebene Verfahren ist prinzipiell auch mit dem Zweierkomplement möglich. Auf eine detaillierte Beschreibung wird hier verzichtet.

Der Wert $(7)_{10} = (111)_2$ für den Toleranzwert $\Delta x_7$ wurde gewählt, um den Toleranzwert auf m=3 binäre Stellen zu begrenzen. Diese m=3 binären Stellen sind im vorliegenden Ausführungsbeispiel die LSBs. Die LSBs des Bezugswerts $(x_i+\bar{x}_i)$ nehmen jeweils den Wert 1 an.

Der Toleranzbereich wird bestimmt, indem vom Bezugswert $(x_i+\bar{x}_i)$ jeweils der Toleranzwert $\Delta x_7$ subtrahiert oder addiert wird. Der einstellbare und damit messbare Toleranzbereich von $-\Delta x_7$ bis $+\Delta x_8$ für die LSBs erstreckt sich bei der Zahlenbereichsdarstellung 3 gemäß Figur 2 von $(120)_{10} = (1111000)_2$ bis $(135)_{10} = (10000111)_2$.

Das MSB gibt das Vorzeichen des sich aus der Gleichung (3) ergebenden Werts an. Ist dieser Wert negativ, so nimmt das MSB den Wert 0 an. Ist der sich aus der Gleichung (3) ergebende Wert positiv, so hat das MSB den Wert 1.

Die in dem Toleranzbereich $2\Delta x_q$ liegenden Zahlenwerte können eindeutig aus dem MSB und aus den LSBs detektiert werden, denn die Bitstellen $y_k$ nehmen bei einem negativen Vorzeichen, d.h. bei einem Wert 0 des MSB den Wert 1 und bei einem positiven Vorzeichen, d.h. bei einem Wert 1 des MSB den Wert 0 an.

Die folgende Gleichung (4) gibt den Minimumterm bzw. den Minterm für $-\Delta x_4$ aus Figur 2 an.

$$-\Delta x_4 = \overline{MSB} \wedge (y_4 \wedge y_3 \wedge y_2 \wedge y_1) \wedge (\overline{LSB}_3 \wedge LSB_2 \wedge LSB_1) \quad (4)$$

Der in Gleichung (4) dargestellte Minterm gibt die messbare Umsetzung des Werts $x_p+\bar{x}_i-\Delta x_4$ für den Referenzwert $x_i = (50)_{10}$ an. Die Bitstellen, die dabei den Wert 0 annehmen, nämlich das MSB und das vorderste LSB werden dabei komplementär dargestellt, um diese Stellen mittels einer 1 messen zu können. Dies entspricht schaltungstechnischem Fachwissen und wird hier nicht näher erläutert.

Bei Auftreten des Tripels $(x_p; x_i; \Delta x_q) = ((46)_{10}; (50)_{10}; -\Delta x_4)$ sollen sowohl die Toleranzanalyse als auch der Produktionstest als Ausgangswert $x_a$ eine 1 generieren. Für die Toleranzanalyse bedeutet dies, dass der Messwert $x_p = (46)_{10}$ vom Referenzwert $x_i = (50)_{10}$ genau $\Delta x_q = -(4)_{10}$ entfernt liegt. Für den Produktionstest bedeutet dies, dass der Messwert $x_p = (46)_{10}$ innerhalb des Toleranzbereichs $x_i \pm \Delta x_i = (50 \pm 4)_{10}$ liegt.

Würde man bspw. als Toleranzwert den Wert $\Delta x_0 = 0$ wählen, so würden sowohl die Toleranzanalyse als auch der Produktionstest für das Tripel $((46)_{10}; (50)_{10}; +\Delta x_0)$ einen Ausgangswert $x_a = 0$ generieren, der das Nichtbestehen des Tests durch den Messwert $x_p$, also ein "Fail" signalisiert.

Bei der Durchführung eines Produktionstests werden in der Regel eine Vielzahl von Messwerten $x_p$ nacheinander generiert und überprüft. Dabei soll beim Auftreten eines nicht im Toleranzbereich liegenden Messwertes $x_p$ dieses

Ergebnis gespeichert und somit auch für alle nachfolgenden Messwerte $x_p$ ein Ausgangswert $x_a$=0 generiert werden, unabhängig davon, ob die nachfolgenden Messwerte $x_p$ im Toleranzbereich liegen und der jeweils diesen Messwerten $x_p$ zugeordnete Ausgangswert $x_a$ den Wert 1 annehmen würde.

Bei der Toleranzanalyse sollen alle auftretenden Ausgangswerte $x_a$=1 nach den Toleranzwerten $\Delta x_q$ sortiert werden. Dies wird auch als Binning bezeichnet.

Aus der Zahlenbereichsdarstellung 3 wird deutlich, dass zur Bestimmung der Lage des Messwerts $x_p$ im Toleranzbereich nur die LSBs betrachtet zu werden brauchen. Das MSB sowie die $y_k$ weisen im Toleranzbereich jeweils eine nahezu identische Struktur auf. Durch das derartige erfindungsgemäße Vorgehen kann der Hardwareaufwand bei der hier vorgenommenen Toleranzanalyse sehr gering gehalten werden.

Figur 3 zeigt ein Prinzipschaltbild einer ersten Toleranzanalyseschaltung 4 mit einem Subtrahierer 41 und mit einem Toleranzfilter 42.

Dabei sind der Subtrahierer 41 und der Toleranzfilter 42 jeweils als Rechtecke und die Ein- und Ausgabevariablen des Subtrahierers 41 und des Toleranzfilters 42 jeweils in Form von Pfeilen dargestellt. In den in Figur 3 links vom Toleranzfilter 42 angeordneten Subtrahierer 41 fließen als Eingabevariablen der vorgebbare Referenzwert $x_i$ und der durch einen in Figur 3 nicht gezeigten Schaltkreis generierte Messwert $x_p$ als Eingabegrößen ein. Der Subtrahierer 41 bildet die Differenz $x_p$-$x_i$ und leitet diesen Differenzwert an den Toleranzfilter 42 weiter.

Der Toleranzfilter 42 kann wahlweise im Diagnosemodus sowie im Produktionstestmodus betrieben werden. Die Auswahl dieser beiden Modi erfolgt dabei durch die Modusauswahlvariable "Set", die für die Auswahl des Diagnosemodus den Wert 1 und des Produktionstestmodus den Wert 0 annimmt.

Der Toleranzwert $\Delta x_q$ stellt eine weitere Eingangsgröße des Toleranzfilters 42 dar. Aus dem vom Subtrahierer 41 bereitgestellten Differenzwert $x_p$-$x_i$ und aus dem Toleranzwert $\Delta x_q$ erzeugt der Toleranzfilter 42 abhängig von dem über die Modusauswahlvariable "Set" ausgewählten Modus nach den Gleichungen (1) oder (2) einen im vorliegenden Ausführungsbeispiel 1-Bit-wertigen Ausgangswert $x_a$, der den Wert 0 (Fail) oder den Wert 1 (Pass) annehmen kann.

Beim Betrieb der ersten Toleranzanalyseschaltung 4 im Diagnosemodus (Set=1) wird bei gegebenem Referenzwert $x_i$= $(50)_{10}$ und gegebenem Toleranzwert $\Delta x_q$=$(4)_{10}$ für den Messwert $x_p$ = ($(46)_{10}$ ein Ausgangswert $x_a$=1 erzeugt. Für alle von $x_p$=$(46)_{10}$ verschiedenen Messwerte $x_p$ ist die Gleichung (1) nicht erfüllt, was zum Erzeugen und Ausgeben des Ausgangswerts $x_a$=0 führt.

Beim Betrieb der ersten Toleranzanalyseschaltung 4 im Produktionstestmodus (Set=0) wird bei gegebenem Referenzwert $x_i$= $(50)_{10}$ und bei gegebenem Toleranzwert $\Delta x_q$ = $(4)_{10}$ für alle Messwerte $x_p$, die im Toleranzbereich gemäß der Gleichung (2) liegen, ein Ausgangswert $x_a$=1 erzeugt. Der Messwert $x_p$ liegt in diesem Toleranzbereich, demzufolge beträgt für den Messwert $x_p$ =$(46)_{10}$ der Ausgangswert $x_a$=1.

Figur 4 zeigt ein weiteres Prinzipschaltbild der ersten Toleranzanalyseschaltung 4 mit einem höheren Detaillierungsgrad.

Bei der Darstellung in Figur 4 sind an den Pfeilen, welche die Ein- und Ausgabevariablen bezeichnen, jeweils Parameter angegeben, welche die zur Darstellung der jeweiligen Variablen im Binärsystem notwendige Bitanzahl repräsentieren. Der Subtrahierer 41 ist in Figur 4 durch den Komplementaddierer 43 ersetzt, der gemäß der Gleichung (3) den Messwert $x_p$ mit dem Einserkomplement $\overline{x}_i$ des Referenzwerts $x_i$ addiert. Dabei ist derjenige Eingang des Komplementaddierers 43, dem der Referenzwert $x_i$ zugeführt wird, invertiert ausgebildet. Der Messwert $x_p$ sowie der Referenzwert $x_i$ sind dabei jeweils n-bit-wertig, der von dem Komplementaddierer 43 gebildete Wert $x_p+\overline{x}_i$ ist (n+1)-bit-wertig ausgebildet.

Der Toleranzfilter 42 umfasst in Figur 4 einen fine filter bzw. Feinfilter FIF, einen coarse filter bzw. Grobfilter COF und ein flag register bzw. Merkerregister FLR. Der (n+1)-bit-wertige Ausgabewert $x_p+\overline{x}_i$ des Komplementaddierers 43 wird in die m niederwertigen Bits, nämlich in die LSBs, die dem Feinfilter FIF zugeführt werden und in die (n+1-m) vorderen Bits aufgespalten, nämlich das MSB und die $y_k$-Bits, die dem Grobfilter COF zugeführt werden.

Der Grobfilter COF untersucht das MSB und die $y_k$-Bits. Zur Untersuchung dieser Bits kann der Grobfilter COF relativ einfach aufgebaut sein, wie nachfolgend in Figur 5 gezeigt ist, denn die vom Grobfilter COF zu untersuchenden Bits sind nahe des Referenzwerts $x_i+\overline{x}_i$, jeweils sehr ähnlich. Der Grobfilter COF liefert eine 2-bit-wertige Antwort an den Feinfilter FIF, die besagt, ob der Messwert $x_p$ größer oder kleiner als der Referenzwert $x_i$ ausgebildet ist.

Der Feinfilter FIF nimmt einen (n+1)-bit-wertigen-Toleranzwert $\Delta x_q$ auf, dessen m Bits die LSBs aufweisen und dessen (m+1)-tes-Bit eine Information darüber enthält, ob der Toleranzwert $\Delta x_q$ oberhalb oder unterhalb des Referenzwerts $x_i$ angesiedelt ist.

Aus dem Toleranzwert $\Delta x_q$, aus dem vom Grobfilter zur Verfügung gestellten Wert und aus den LSBs des Messwerts $x_p$ berechnet der Feinfilter FIF eine 1-bit-wertige Messantwort D, die besagt, ob der Messwert $x_p$ die im Feinfilter FIF stattgefundene Überprüfung bestanden oder nicht bestanden hat. Der dabei im Feinfilter FIF vorzunehmende Testmodus ist, wie bereits mit Bezug auf Figur 3 erläutert, durch die Modusauswahlvariable "Set" einstellbar.

Die vom Feinfilter FIF erzeugte Messantwort D wird gemäß Figur 4 dem Merkerregister FLR zugeleitet. Dieses Merkerregister FLR kann unterschiedlich ausgebildet sein.

Im Diagnosemodus werden die Messantworten D des Feinfilters FIF vom Merkerregister FLR als Ausgangs-

werte $x_a$ ausgegeben. Der Diagnosemodus wird nämlich häufig bei der Chipentwicklung eingesetzt, bei der erfahrungsgemäß noch einige Fehler auftreten und bei der es wichtig ist, jeden einzelnen Fehler zu erfassen, um ihn verbessern zu können.

Beim Produktionstestmodus ist es wichtig, zu detektieren, ob der fertige Chip fehlerfrei funktioniert, da schon das Auftreten eines einzigen Fehlers den Chip unbrauchbar machen kann. Dementsprechend wird bei Auftreten eines einzigen Fehlers der Ausgang $x_a$ dauerhaft auf 0 (Fail) gesetzt. Dabei ist das Merkerregister FLR so ausgebildet, dass es die Messantworten D vom Feinfilter FIF überprüft und als Ausgangswerte $x_a$ ausgibt, solange die Messantworten jeweils den Wert 1 annehmen. Sobald eine Messantwort D=0 vom Merkerregister FLR registriert wird, so werden die Ausgangswerte $x_a$ dauerhaft auf 0 gesetzt.

Figur 5 zeigt eine Grobfilter-Gatterdarstellung 5 des Grobfilters COF aus Figur 4.

Der Grobfilter COF gliedert sich in ein NOR-Gatter 51 und in ein erstes NAND-Gatter 52. Die (n-m)-bit-wertigen $y_k$-Bits und das 1-bit-wertige MSB werden dabei jeweils dem NOR-Gatter 51 und dem ersten NAND-Gatter 52 zugeführt, wobei das MSB jeweils invertiert wird. Als Ausgabevariable des NOR-Gatters 51 ergibt sich der 1-Bit-Wert MSB-. Als Ausgabevariable des ersten NAND-Gatters 52 ergibt sich der 1-Bit-Wert $MSB_+$. Die Variablen MSB- und $MSB_+$ können dabei jeweils die Werte 0 oder 1 annehmen. Die Werte MSB-=$MSB_+$=0 sagen aus, dass der Messwert $x_p$ kleiner als der Referenzwert $x_i$ ist, aber noch innerhalb des maximal gültigen Toleranzbereichs liegt. Die Werte MSB-=$MSB_+$=1 sagen jeweils aus, dass der Messwert $x_p$ größer als der Referenzwert $x_i$ ist, aber noch innerhalb des maximal gültigen Toleranzbereichs liegt.

Die Indizes p, i und q des Messwerts $x_p$, des Referenzwerts $x_i$ und des Toleranzwerts $\Delta x_q$ stellen jeweils Laufvariablen dar. Dabei sind die Referenzwerte $x_i$ und die Toleranzwerte $\Delta x_q$ voneinander entkoppelt, denn ihre Laufvariablen sind unterschiedlich ausgebildet. Das bedeutet, dass für einen Messwert $x_p$ bspw. zwei Referenzwerte $x_i$ und jeweils vier Toleranzwerte $\Delta x_q$ gewählt werden können. Stimmen die Laufvariablen des Referenzwerts $x_i$ und des Toleranzwerts $\Delta x_q = \Delta x_i$ überein, so wird jeweils eine gleiche Anzahl von Referenzwerten $x_i$ und Toleranzwerten $\Delta x_i$ für einen Messwert $x_p$ betrachtet.

Die Grobfilter-Gatterdarstellung 5 stellt lediglich ein Beispiel für eine hardwaremäßige Realisierung des Grobfilters COF dar. Es sind eine Vielzahl anderer Hardware-Realisierungen des Grobfilters COF denkbar, welche die beschriebene Funktionalität haben.

Figur 6 zeigt eine Merkerregister-Gatterdarstellung 6 sowie eine zugehörige Merkerregister-Wahrheitstabelle 7.

Die Merkerregister-Gatterdarstellung 6 umfasst ein zweites NAND-Gatter 61, ein drittes NAND-Gatter 62, ein viertes NAND-Gatter 63 sowie ein Oder-Gatter 64. Die bei der Merkerregister-Gatterdarstellung 6 links oben dargestellte Modusauswahlvariable Set sowie die links unten dargestellte Messantwort D stellen die Eingangsgrößen des in Figur 6 gezeigten Merkerregisters FLR dar. Der bei der Merkerregister-Gatterdarstellung 6 rechts unten gezeigte Ausgangswert $x_a$ stellt die von dem Merkerregister FLR erzeugte Ausgangsgröße dar, die Hinweise auf die Qualität des Messwerts $x_p$ gibt.

Das zweite NAND-Gatter 61 weist einen invertierten Eingang für die Modusauswahlvariable Set, einen weiteren Eingang für die Messantwort D vom Feinfilter FIF und einen Eingang vom vierten NAND-Gatter 63 auf. Das dritte NAND-Gatter 62 umfasst einen Eingang für die Modusauswahlvariable Set und einen weiteren Eingang für die Messantwort D vom Feinfilter FIF. Das vierte NAND-Gatter 63 umfasst einen Eingang vom zweiten NAND-Gatter 61 und einen invertierten Eingang für die Modusauswahlvariable Set. Das Oder-Gatter 64 umfasst einen Eingang vom vierten NAND-Gatter 63 und einen weiteren Eingang vom dritten NAND-Gatter 62.

Die Merkerregister-Wahrheitstabelle 7 umfasst neun Zeilen und fünf Spalten. In der obersten Zeile sind die Überschriften "Set", "D", "$x_a(t\text{-}1)$", "$x_a(t)$" und "verwendeter Modus" der in den übrigen Zeilen enthaltenen Werte gezeigt. Die letzte Spalte "verwendeter Modus" dient dabei der Erläuterung und taucht in den in der Praxis verwendeten Wahrheitstabellen häufig nicht auf.

In den Zeilen zwei bis neun sind alle denkbaren Kombinationen der Eingabegröße Set, D und des vorherigen Ausgangswerts $x_a(t\text{-}1)$ sowie der für diese Eingabegrößen jeweils gewünschte Ausgabewert $x_a(t)$ zur Zeit t enthalten. Die Zeilen zwei bis fünf weisen dabei den Wert 1 und die Zeilen sechs bis neun jeweils den Wert 0 für die Modusauswahlvariable Set auf. Dementsprechend wird das Merkerregister FLR und somit die gesamte erste Toleranzanalyseschaltung 4 in den Zeilen zwei bis fünf im Diagnosemodus und in den Zeilen sechs bis neun im Produktionstestmodus betrieben.

Wahrheitstabellen, wie die Merkerregister-Wahrheitstabelle 7 stellen in der Praxis häufig die Vorlage für eine zu realisierende elektrische Schaltung bzw. für eine zu realisierende Gatterdarstellung dar. Die auch als Synthetisierung bezeichnete Umsetzung einer solchen Wahrheitstabelle in eine Gatterdarstellung bzw. in eine reale elektrische Schaltung erfolgt dabei weitgehend automatisiert unter Verwendung geeigneter Computerprogramme. Ein Benutzereingriff oder gar die manuelle Erzeugung einer Gatterdarstellung, wie der Merkerregister-Gatterdarstellung 6 entfällt dabei völlig.

Die Merkerregister-Gatterdarstellung 6 stellt ein Beispiel für eine hardwaremäßige Realisierung des Merkerregisters FLR dar. Es sind eine Vielzahl anderer Hardware-Realisierungen des Merkerregisters FLR möglich, welche die in der Merkerregister-Wahrheitstabelle 7 angegebene Funktionalität umsetzen.

Einem Fachmann ist klar, dass die Messantwort D im Produktionstestmodus nur gespeichert werden darf, wenn sie stabil ist. Durch zusätzliche, hier nicht näher beschriebene Schaltungsmaßnahmen ist zu vermeiden, dass kurzzeitige Signalwechsel während der Verarbeitung gespeichert werden.

Figur 7 zeigt eine Feinfilter-Blackboxdarstellung 8 des Feinfilters FIF mit einer Feinfilter-Blackbox 81 sowie mit in Form von Pfeilen dargestellten Ein- und Ausgabevariablen.

Die an den Pfeilen angegebenen Werte stellen dabei jeweils die Anzahl der Bits der betreffenden Ein- oder Ausgabevariablen dar. Die Feinfilter-Blackboxdarstellung 8 entspricht dem Ausschnitt des Feinfilters FIF aus Figur 4, wobei die Variablennamen explizit angegeben sind.

Die vom Subtrahierer 41 bzw. vom Komplementaddierer 43 zur Verfügung gestellten m-bit-wertigen LSBs des gebildeten Werts $x_p$-$x_i$ bzw. $x_p+\bar{x}_i$, bilden die erste Eingabevariable des Feinfilters FIF. Die vom Grobfilter COF bereitgestellten je 1-bit-wertigen Variablen MSB- und $MSB_+$ bilden die zweite und die dritte Eingabevariable des Feinfilters FIF. Die 1-bit-wertige Modusauswahlvariable Set bildet eine weitere Eingabegröße des Feinfilters FIF. Die letzte Eingabegröße des Feinfilters FIF wird durch den (m+1)-bit-wertigen Toleranzwert $\Delta x_q$ gebildet.

Abhängig von diesen Eingabewerten erzeugt der Feinfilter FIF eine 1-bit-wertige Messantwort D, welche die Ausgabevariable des Feinfilters FIF bildet. Die genaue Funktion des Feinfilters FIF ergibt sich für den Fachmann aus der Prüfung der in den Gleichungen (1) und (2) enthaltenen Bedingungen.

Figur 8 zeigt eine dem Feinfilter FIF zugrundeliegende Feinfilter-Wahrheitstabelle 9.

Die Feinfilter-Wahrheitstabelle 9 weist auf ihrer linken Seite den für das vorliegende Ausführungsbeispiel relevanten Bereich aus der Zahlenbereichsdarstellung 3 auf, und zwar den Bereich von $x_p=(120)_{10}=(1111000)_2$ bis $x_p=(135)_{10}=(10000111)_2$. Daneben sind in zwei Spalten die den Zahlen aus der Zahlenbereichsdarstellung 3 entsprechenden Werte der Variablen MSB- und $MSB_+$ gezeigt.

Der rechts davon dargestellte Bereich der Feinfilter-Wahrheitstabelle 9 untergliedert sich in einen linken Bereich für den Diagnosemodus, bei dem die Modusauswahlvariable Set den Wert 1 annimmt und in einen rechten Bereich für den Produktionstestmodus, bei dem die Modusauswahlvariable Set den Wert 0 annimmt. Für den Zahlenbereich von $x_p=(120)_{10}=$ (01111000) bis $x_p=(135)_{10}=(10000111)_2$ umfasst sowohl der Bereich des Diagnosemodus als auch der Bereich des Produktionstestmodus jeweils eine 16x16-Matrix, welche die Messantworten D=[0; 1] für die jeweils darüber dargestellten Toleranzwerte $\Delta x_q$ und für die jeweils darunter dargestellten Werte von $\Delta x_m$ aufweisen. Die oberhalb der beiden 16x16-Matrizen dargestellten Toleranzwerte $\Delta x_q$ verlaufen sowohl für den Diagnosemodus als auch für den Produktionstestmodus jeweils im Zahlenbereich von -7 bis +8. Dabei ist für den Diagnosemodus jeweils der Toleranzwert $\Delta x_q$ und für den Produktionstestmodus jeweils der Toleranzwertbetrag $|\Delta x_q|$ betrachtet. Unterhalb der beiden 16x16-Matrizen sind jeweils die der letzten Stelle von $y_k$ und den LSBs entsprechenden Werte $\Delta x_m$ gezeigt. Die Werte $\Delta x_m$ verlaufen sowohl für den Diagnosemodus als auch für den Produktionstestmodus jeweils von $\Delta x_m=(8)_{10}=(1000)_2$ bis $\Delta x_m=(15)_{10}=(1111)_2$ sowie von $\Delta x_m=0_{2;10}$ bis $\Delta x_m=(7)_{10}=(0111)_2$.

Im Diagnosemodus nehmen nur die auf der Hauptdiagonalen der 16x16-Matrix angeordneten Messantworten D den Wert 1 an. Die nicht auf der Hauptdiagonalen der 16x16-Matrix liegenden Messantworten D weisen jeweils den Wert 0 auf.

Im Produktionstestmodus sind bei der 16x16-Matrix die auf der Hauptdiagonalen, die auf der Nebendiagonalen, sowie die im linken Bereich dieser Matrix von der Haupt- und von der Nebendiagonalen eingeschlossenen Werte sowie die im rechten Bereich dieser Matrix von der Neben- und von der Hauptdiagonalen eingeschlossenen Messantworten D den Wert 1 an. Die übrigen Messantworten D nehmen den Wert 0 an.

Die in den im vorliegenden Ausführungsbeispiel beschriebenen 16x16-Matrizen des Diagnosemodus bzw. des Produktionstestmodus enthaltenen Messantworten D stellen dabei die Ausgabegrößen, die übrigen Werte MSB, $y_k$, LSBs, MSB-, $MSB_+$, $\Delta x_q$ bzw. $|\Delta x_q|$ sowie $\Delta x_m$ stellen die Eingabegrößen dar.

In der Praxis der Schaltungsentwicklung stellen Wahrheitstabellen, wie die in Figur 8 gezeigte Feinfilter-Wahrheitstabelle 9 eine vollständige Vorlage für die Erzeugung einer Gatterdarstellung und schließlich für die zu entwickelnde elektrische Schaltung dar. Eine solche vollständige Vorgabe einer elektrischen Schaltung kann auch in Form von mathematischen Funktionen vorgegeben sein.

Basierend auf einer solchen Wahrheitstabelle oder auf einer Anzahl von mathematischen Funktionen wird eine Gatterdarstellung einer elektrischen Schaltung mittels geeigneten, dem Fachmann bekannten Computerprogrammen, sogenannten Synthese-Tools erzeugt. Bei der Erstellung solcher Gatterdarstellungen werden die Werte der beschriebenen Ein- und Ausgabevariablen an das verwendete Synthese-Tool angelegt, woraufhin das Synthese-Tool selbständig eine Gatterdarstellung erzeugt.

Die Erläuterung der Erstellung einer Gatterdarstellung mittels eines Synthese-Tools aus dieser Feinfilter-Wahrheitstabelle 9 ist hochkomplex und erfordert einen großen Erklärungsaufwand. Des weiteren sind eine Vielzahl von Gatterdarstellungen denkbar, welche die Feinfilter-Wahrheitstabelle 9 umsetzen. Dementsprechend wird auf eine Angabe einer konkreten, aus der Feinfilter-Wahrheitstabelle 9 erzeugten Gatterdarstellung verzichtet, zumal eine solche exemplarische Gatterdarstellung zur Erklärung der Erfindung nichts bereitstellen könnte, was nicht ohnehin aus Figur 8 und der entsprechenden Figurenbeschreibung hervorgeht.

Figur 9 zeigt eine Toleranzanalyseanordnung 10 mit der ersten Toleranzanalyseschaltung 4, mit einem Test-Schaltkreis DUT sowie mit einem Speicherbereich 11.

Der Speicherbereich 11 umfasst dabei eine Referenzwertdatenbank 12 sowie einen Zähler 13. Die erste Toleranzanalyseschaltung 4 ist dabei so mit dem Test-Schaltkreis DUT verbunden, dass sie von dem Test-Schaltkreis DUT erzeugte Messwerte $x_p$ empfangen und verarbeiten kann. Die erste ToleranzanalyseSchaltung 4 ist so mit dem Speicherbereich 11 verbunden, dass sie Referenzwerte $x_i$ sowie Toleranzwerte $\Delta x_q$ von der Referenzwertdatenbank 12 empfangen und den von ihr erzeugten Ausgabewert $x_a$ an den Zähler 13 weiterleiten kann. Der Test-Schaltkreis DUT ist mit wenigstens einem seiner Anschlussfinger bzw. Pins an ein geeignetes in Figur 9 nicht gezeigtes Messinstrument angeschlossen, das in der Lage ist, den Test-Schaltkreis mit Teststimuli $x_k$ zu beaufschlagen. Die Eingangsleitung für die Teststimuli $x_k$ weist dabei im Ausführungsbeispiel gemäß Figur 9 eine Verzweigung auf, die den Teststimulus $x_k$ auch an den Speicherbereich 11, insbesondere an die Referenzwertdatenbank 12 weiterleitet.

In der Praxis wird ein Teststimulus $x_k$ auch als Eingangsbelegung oder als Sample bezeichnet. Beim Betrieb der ersten Toleranzanalyseanordnung 10 wird von dem Messgerät ein erster Teststimulus $x_k$ erzeugt und an den Test-Schaltkreis DUT angelegt. Parallel dazu wird der erste Teststimulus $x_k$ auch der Referenzwertdatenbank 12 zugeleitet.

Des weiteren wird die Modusauswahlvariable Set als Eingangsvariable an die erste Toleranzanalyseschaltung 4 angelegt. In der häufigsten Betriebsart der ersten Toleranzanalyseanordnung 10 wird die Modusauswahlvariable Set vor der Erzeugung der Teststimuli $x_k$ festgelegt und an die erste Toleranzanalyseschaltung 4 angelegt. Es ist jedoch ebenfalls denkbar, parallel zu der Erzeugung jedes einzelnen Teststimulus $x_k$ auch die Modusauswahlvariable "Set" jedes mal neu zu erzeugen und an die erste Toleranzanalyseschaltung 4 anzulegen.

Der Test-Schaltkreis DUT verarbeitet den Teststimulus $x_k$ und erzeugt einen Messwert $x_p$, der vom Test-Schaltkreis DUT ausgegeben und an den Eingang der ersten Toleranzanalyseschaltung 4, insbesondere an den Komplementaddierer 43 weitergegeben wird.

Parallel dazu erfolgt in der Referenzwertdatenbank 12 eine eindeutige Zuordnung des ersten Teststimulus $x_k$ zu einem oder mehreren Referenzwerten $x_i$ und zu einem oder mehreren Toleranzwerten $\Delta x_q$. Die Anzahl der dem Teststimulus $x_k$ dabei zugeordneten Referenzwerte $x_i$ kann sich dabei von der Anzahl der dem Teststimulus $x_k$ zugeordneten Referenzwerte $\Delta x_q$ unterscheiden, wenn die Laufvariablen i und q des Referenzwerts $x_i$ und des Toleranzwerts $\Delta x_q$ unterschiedlich ausgebildet sind. Falls für beide Werte genau eine Laufvariable vorgesehen ist,- so ist die Anzahl der dem Teststimulus $x_k$ zugeordneten Referenzwerte $x_i$ und Toleranzwerte $\Delta x_q$ gleich.

Die Referenzwerte $x_i$ und die Toleranzwerte $\Delta x_q$ werden nun nacheinander als Eingangwerte an die erste Toleranzanalyseschaltung 4 angelegt. Wie bereits mit Bezug auf die Figuren 4 bis 8 erläutert, wird nun für jedes Tripel ($x_p$; $x_i$; $\Delta x_q$) ein Ausgabewert $x_a$ erzeugt. Falls für einen Messwert $x_p$ mehrere Referenzwerte $x_i$ sowie mehrere Toleranzwerte $\Delta x_q$ in der Referenzwertdatenbank 12 vorgesehen sind, so werden von der ersten Toleranzanalyseschaltung 4 mehrere Ausgabewerte $x_a$ für den gleichen Messwert $x_p$ erzeugt. Die Anzahl der dabei zu erzeugenden Ausgabewerte $x_a$ entspricht dabei der Anzahl der verschiedenen Tripel ($x_p$; $x_i$; $\Delta x_q$)

Der Zähler 13 wird beim Betrieb der ersten Toleranzanalyseanordnung 10 im Produktionstestmodus (Set=0) nicht benötigt. Das Merkerregister FLR setzt bei dem ersten Auftreten eines nicht im Toleranzbereich liegenden Messwertes $x_p$ den Ausgangwert $x_a$ dauerhaft auf 0. Im Produktionstestmodus kann der Test abgebrochen werden, oder das beschriebene Verfahren wird für den nächsten Teststimulus $x_k$ und für weitere Teststimuli $x_k$ wiederholt, solange bis alle Teststimuli $x_k$ abgearbeitet und für alle Tripel ($x_k$ ; $x_i$ ; $\Delta x_q$) Ausgabewerte $x_a$ erzeugt worden sind.

Im Diagnosemodus (Set=1) gibt das Merkerregister FLR jede vom Feinfilter FIF erhaltene Messantwort D als Ausgabewert $x_a$ weiter. Die Funktion des Merkerregisters FLR, bei der bei Auftreten eines einzigen fehlerhaften Messwerts $x_p$ die Ausgabevariable $x_a$ dauerhaft auf 0 gesetzt wird, ist im Diagnosemodus nicht aktiviert. Dafür ist im Diagnosemodus der Zähler 13 aktiviert, der die Ausgabewerte $x_a$ erfasst und in der Referenzwertdatenbank 12 zu jedem Paar von Referenzwert $x_i$ und Toleranzwert $\Delta x_q$ zuordnet und geeignet ablegt. Auch beim Diagnosemodus wird nach Abarbeitung des ersten Teststimulus $x_k$ das vorgehend beschriebene Verfahren wiederholt, bis alle erzeugten Teststimuli $x_k$ abgearbeitet und für jedes Tripel ($x_p$ ; $x_i$; $\Delta x_q$) ein Ausgabewert $x_a$ erzeugt worden ist.

Beim Diagnosemodus kann nach Abarbeitung des Verfahrens in der Referenzwertdatenbank 12 nachgesehen werden, für welche Paare von Referenzwerten $x_i$ und Toleranzwerten $\Delta x_q$ der Test-Schaltkreis DUT fehlerfreie bzw. fehlerhafte Messwerte $x_p$ geliefert hat.

Der einem Teststimulus $x_k$ entsprechende Referenzwert $x_i$ mit einem bestimmten Toleranzwert $\Delta x_q$ kann aufgrund der Adresse von $x_k$ ausgewählt werden. Für mehrere zu untersuchende Toleranzwerte $\Delta x_q$ ist es möglich, verschiedene Sollwert-Tabellen vorzusehen. Die Abarbeitung dieser Sollwert-Tabellen erfolgt durch eine in Figur 9 nicht gezeigte Steuerung. Die jeweiligen Ausgabewerte $x_a$=1 werden dann in der Referenzwertdatenbank 12 den dazugehörigen Toleranzwerten $\Delta x_q$ zugeordnet und gezählt, was auch als "Binning" bezeichnet wird.

Im Produktionstestmodus wird pro Teststimulus $x_k$ nur ein $\Delta x_q = \Delta x_i$ angelegt. Die Testantwort $x_a$ wird damit in einer 1-Bit-Antwort kompaktiert. Der Begriff "kompaktiert" ist dabei so zu verstehen, dass durch genau einen 1-bitwertigen Ausgangswert $x_a$ festgestellt werden kann, ob alle angelegten Teststimuli $x_k$ von dem Test-Schaltkreis DUT korrekt verarbeitet wurden oder ob bei der Bearbeitung wenigstens eines Teststimulus $x_k$ durch den Test-Schaltkreis DUT ein Fehler aufgetreten ist.

Der gesamte in Figur 9 beschriebene Testaufbau kann durch Logik und Speicher realisiert werden. Die Referenzwertdatenbank 12 sowie der Zähler 13 können dabei durch Standardbibliotheken oder durch Register realisiert werden. Solche Standardbibliotheken und Register sind dem Fachmann bekannt und brauchen hier nicht näher erläutert zu werden.

Figur 10 zeigt eine andere Toleranzanalyseanordnung 14 .

Die Toleranzanalyseanordnung 14 entspricht dabei der Toleranzanalyseanordnung 10 aus Figur 9, wobei die erste Toleranzanalyseschaltung 4 durch eine andere Toleranzanalyseschaltung 15 ersetzt ist. Komponenten, die in der Toleranzanalyseanordnung 10 und in der Toleranzanalyseanordnung 14 übereinstimmen, werden mit gleichen Bezugszeichen gekennzeichnet und nicht noch einmal separat erörtert.

Die Toleranzanalyseschaltung 15 entspricht jedoch lediglich hinsichtlich ihrer Eingabevariablen $x_p$, $x_i$, $\Delta x_q$ und Set, hinsichtlich ihrer Ausgabevariablen $x_a$ sowie hinsichtlich ihrer Funktion der mit Bezug auf die Figuren 3-8 erläuterten ersten Toleranzanalyseschaltung 4 und fällt daher nicht in den beanspruchten Bereich.

Die Toleranzanalyseschaltung 15 braucht dabei nicht in Form eines Subtrahierers 41 bzw. Komplementaddierers 43 in Verbindung mit einem Toleranzfilter 42 ausgestaltet sein, sondern kann z.B. auch als μ-Prozessor, als Gate Array oder als digitaler Signalprozessor DSP vorliegen.

Der Speicherbereich 11 einer als μ-Prozessor ausgebildeten Toleranzanalyseschaltung 15 könnte dabei als Direktzugriffsspeicher (RAM) ausgebildet sein.

Die Funktionsweise und somit der wesentliche Aufbau eines solchen μ-Prozessors, eines solchen Gate Arrays oder eines solchen DSPs ist durch die in der vorliegenden Figurenbeschreibung in Verbindung mit den Figuren gegebenen Informationen so genau definiert, dass ein Fachmann aus den gegebenen Informationen ein solches Bauteil bereits erstellen kann.

Auf eine genauere Darstellung der konkreten Ausgestaltung und des konkreten Aufbaus eines solchen μ-Prozessors, eines solchen Gate Arrays und eines solchen DSPs wird hier aus Gründen der Anschaulichkeit verzichtet, zumal die Darstellung des Aufbaus solcher Bauteilen sehr erklärungsintensiv ist und zumal die Funktionsweise der Toleranzanalyseschaltung 15 durch eine solche Darstellung nicht klarer werden würde, als sie es aus der vorliegenden Beschreibung mit Bezug auf die Figuren 1 bis 8 schon ist.

Ein erstes Anwendungsgebiet der Toleranzanalyseanordnung 14 stellt die allgemeine Toleranzmessung dar. Dabei erzeugen Teststimuli $y_k$ Testantworten bzw. Messwerte $x_p$ an einem Test-Schaltkreis DUT. Für diese allgemeine Toleranzmessung ist es charakteristisch, dass jedem Teststimulus $x_k$ genau ein Referenzwert $x_i$ und ein oder mehrere Toleranzwerte $\Delta x_q$ zugeordnet sind. Der Zähler 13 nimmt nach Abarbeitung der Tripel ($x_p$ ; $x_i$; $\Delta x_{qq}$) jeweils die Anzahl der Treffer für die jeweiligen Toleranzwerte $\Delta x_q$ auf, bei denen der Ausgangswert $x_a$ jeweils den Wert 1 annimmt. Nach Abarbeitung einer Reihe von Teststimuli $x_k$ kann mittels der allgemeinen Toleranzmessung eine Aussage darüber getroffen werden, welche der den Teststimuli $x_k$ eindeutig zuordenbaren Messwerte $x_p$ in den durch die

Toleranzwerte $\Delta x_q$ gegebenen Toleranzklassen $\Delta x_q$ liegen und welche nicht. Somit ist eine präzise Testauswertung für sämtliche Teststimuli $x_k$ anhand der jedem Teststimulus $x_k$ zugeordneten Toleranzwerte $\Delta x_q$ möglich.

Ein weiteres Anwendungsfeld der Toleranzanalyseanordnung 14 stellt der Augendiagrammtest zur Zeit- bzw. Periodendauermessung dar. Bei einem solchen Augendiagrammtest geht es darum, unerwünschte kleine Schwankungen im Zeit- oder Amplitudenverlauf festzustellen. Dies wird auch als Zittern bzw. Flattern bzw. "jitter" bezeichnet. Bei einem solchen Augendiagrammtest nimmt der als Aktivierungssignal bzw. als Strobe ausgebildete Teststimulus $x_k$ jeweils einen festen Wert an. Dabei kann bspw. eine Clock bzw. ein Taktgeber als Messgerät bzw. als Generator für die Aktivierungssignal vorgesehen sein. Bei dem Augendiagrammtest wird davon ausgegangen, dass der Test-Schaltkreis DUT quasi selbständig arbeitet, wobei nur Aktivierungssignale, bspw. in Form von Clock-Signalen als Teststimuli $x_k$ angelegt zu werden brauchen. Bei dem Augendiagrammtest werden sämtliche Testantworten bzw. Messwerte $x_p$ des Test-Schaltkreises DUT gesucht, die eine definierte Augenöffnung nicht überschreiben bzw. einen definierten zeitlichen Toleranzbereich $\Delta x_q$ nicht verlassen. Die Messwerte $x_p$ repräsentieren für die horizontale Augenöffnung digitalisierte Periodendauerwerte und für die vertikale Augenöffnung digitalisierte Amplitudenwerte. Die Referenzwerte $x_i$ und die Toleranzwerte $\Delta x_q$ werden entsprechend dem Ort der Auswertung des Auges bzw. des Aktivierungssignal gewählt. Für steigende und fallende Clock-Flanken können diese Werte auch unterschiedlich gewählt werden. Bspw. sind für eine Augenmaske aus sechs Punkten sechs Einstellungen des Referenzwerts $x_i$ und des Toleranzwerts $\Delta x_q$ zu wählen.

Eine weitere Anwendung der Toleranzanalyseanordnung 14 stellt die Data-Dependent-Jitter-Analyse bzw. die datenabhängige Signalschwankungsanalyse dar. Bei der datenabhängigen Signalschwankungsanalyse ist jedem Teststimulus $x_k$ eindeutig genau ein Referenzwert $x_i$ sowie genau ein Toleranzwert $\Delta_{xq}=\Delta x_i$ zugeordnet. Der Referenzwert $x_i$ und der Toleranzwert $\Delta x_i$ haben somit jeweils die gleiche Laufvariable. Bei der datenabhängigen Signalschwankungsanalyse wird für jeden auch als Golden Data bezeichneten Teststimulus $x_k$ die Testantwort bzw. der Messwert $x_p$ des Test-Schaltkreises DUT in Toleranzklassen $\Delta x_q$ einsortiert. Die Messwerte $x_p$ stellen dabei Periodendauerwerte dar, die mit den Referenzwerten $x_i$ verglichen werden. Im Produktionstestmodus ist dabei ein Toleranzwert $\Delta x_q$ festgelegt, der durch keinen von einem Teststimulus $x_k$ erzeugten Messwert $x_p$ überschritten werden darf. Im Diagnosemodus sind die einzelnen Felder des Zählers 13 den Toleranzklassen $\Delta x_q$ zugeordnet.

Gemäß einer weiteren Anwendung kann die Toleranzanalyseanordnung 14 für einen DAC-ADC-Test bzw. für einen Digigal/Analog-Wandler-Analog/Digital-Wandler-Test oder für einen ADC-Test bzw. für einen Analog/Digital-Wandler-Test eingesetzt werden. Der Test-Schaltkreis DUT wird bei einem solchen DAC-ADC-Test durch einen Digital/ Analog-Wandler sowie durch einen Analog/Digital-Wandler gebildet, die bspw. in einem Basisband bzw. in einem Base Band oder in einem Sprachbandschleifentest bzw. in einem Voice Band Loop Test zu finden ist. Dabei wird getestet, ob die angelegten als Amplitudenwerte ausgebildeten Teststimuli $x_k$ die entsprechenden Ausgabewerte $x_a$ in Form von Amplitudenwerten liefern. Dabei stellen die Teststimuli $x_k$, die Messwerte $x_p$ und die Ausgabewerte $x_a$ Amplitudenwerte dar, die zur Digitalisierung von physikalischen Größen, bspw. von Strom- und Spannungsverläufen benötigt werden. Bei einem korrekt arbeitenden Test-Schaltkreis DUT liegt der Messwert $x_p$ eines Teststimulus $x_k$ innerhalb eines akzeptierten Toleranzbereichs $\Delta x_q$=$\Delta x_i$ des als Referenzamplitude ausgebildeten Referenzwerts $x_i$=$x_k$. Somit weisen beim DAC-ADC-Test der Teststimulus $x_k$, der Referenzwert $x_i$ und der Toleranzwert $\Delta x_q$ jeweils dieselbe Laufvariable auf. Der DAC-ADC-Test liefert in der Regel statistische Aussagen. Das Anlegen der Testmüster $x_k$ kann unter bestimmten Voraussetzungen auch willkürlich erfolgen. Als Generator der Teststimuli $x_k$ ist damit auch die Verwendung eines Pseudo-Random-Bit-Generators (PRB-Generators) denkbar. Benachbarte Teststimuli $x_k$ dürfen höchstens eine durch die Spezifikation des Test-Schaltkreises DUT vorgegebene Abweichung aufweisen. Der Zähler 13 nimmt die Anzahl der Treffer bzw. der 1-bit-Werte des Ausgabewerts $x_a$ für die jeweils betrachtete Toleranzklasse $\Delta x_q$ auf. Im Diagnosemodus können mehrere Toleranzklassen $\Delta x_q$ pro vorliegender Referenzamplitude $x_i$=$x_k$ aufgenommen werden. Die gängige Teststrategie bei dem DAC-ADC-Test besteht darin, eine sogenannte Rampe, die bspw. in stark ansteigenden Teststimuli $x_k$ bestehen kann, durchzuspielen und dabei die korrekte Funktionsweise des Test-Schaltkreises DUT für sämtliche Messwerte $x_p$ zu überprüfen. Eine weitere denkbare Anwendung der Toleranzanalyseanordnung 14 stellt der Pseudo-Random-Bit-Test (PRB-Test) dar. Hier wird eine deterministische Zufallsfolge von Teststimuli $x_k$ an den Test-Schaltkreis DUT angelegt. Die Testantwort bzw. der Messwert $x_p$ wird mit dem Referenzwert $x_i$ verglichen. Im Diagnosemodus wird der Toleranzwert $\Delta x_q$ zugeordnet. Der Zähler 13 nimmt die Häufigkeit des Auftretens eines Messwerts $x_p$ innerhalb der Toleranzklassen $\Delta x_q$ auf. Im Produktionstestmodus werden alle Messwerte $x_p$ in einer 1-bit-wertigen Testantwort $x_a$ am Ausgang kompaktiert, die eine Aussage (Pass/ Fail) über die Funktionsfähigkeit des Test-Schaltkreises DUT trifft. Jedem Referenzwert $x_i$ wird über die Adresse des Teststimulus $x_k$ ein Referenzwert $x_i$, ein Toleranzwert $\Delta x_q$ =$\Delta x_i$, sowie ein Zähler 13 mit der Laufvariable i zugeordnet. Somit verfügen der Referenzwert $x_i$, der Toleranzwert $\Delta x_i$ sowie der Zähler 13 über dieselbe Laufvariable i.

## Patentansprüche

**1.** Elektrische Toleranzanalyseschaltung zur Toleranzanalyse von digitalen und digitalisierten Messwerten mit den folgenden Mermalen:

- ein erster Eingang zum Empfang eines n-bit-wertigen Messwerts $x_p$,
- ein zweiter Eingang zum Empfang eines n-bit-wertigen Referenzwerts $x_i$,
- ein dritter Eingang zum Empfang eines (m+1) -bit-wertigen Toleranzwerts $\Delta x_q$,
- eine Überprüfungseinrichtung (41, 42) zum Überprüfen des Messwerts $x_p$ anhand wenigstens eines vorgebbaren Toleranzkriteriums,
- eine Ausgabeeinrichtung zur Ausgabe eines Ausgangswerts ($x_a$), der sich aus dem Zustand der Überprüfungseinrichtung (41, 42) ergibt, und zwar in Abhängigkeit davon, ob der Messwert $x_p$ das jeweils vorgegebene Toleranzkriterium erfüllt oder nicht,

wobei die Überprüfungseinrichtung (41, 42) einen Subtrahierer (41) sowie einen mit dem Subtrahierer (41) verbundenen Toleranzfilter (42) aufweist,

wobei der Subtrahierer (41) den ersten Eingang zum Empfang des Messwerts $x_p$ und den zweiten Eingang zum Empfang des Referenzwerts ($x_i$) aufweist,
wobei der Subtrahierer (41) so ausgebildet ist, dass ein Differenzwert ($x_p$-$x_i$) aus dem Messwert $x_p$ und aus dem Referenzwert $x_i$ an einem Ausgang des Subtrahierers (41) erzeugt wird,
wobei der Toleranzfilter (42) den dritten Eingang zum Empfang des Toleranzwerts $\Delta x_q$ und einen weiteren mit dem Ausgang des Subtrahierers (41) verbandenen vierten Eingang aufweist und wobei der Toleranzfilter (42) so ausgebildet ist, dass der Ausgangswert ($x_u$) unter Verwendung des Toleranzwerts $\Delta x_q$ und des vom Subtrahierer (41) bereitgestellten Differnzwerts ($x_p$ - $x_i$) erzeugt wird,
wobei der Toleranzfilter (42) einen Grobfilter (COF), einen Feinfilter (FIF) und ein Merkerregiater (FLR) aufund der Grobfilter (COF) die (n+1-m) vorderen Bits des vom Subtrahierer (41) erzeugten Differenzwerts ($x_p$ - $x_i$) verarbeitet, wobei der Grobfilter (COF) so ausgebildet ist, dass er eine Ausgabe an einem Ausgang des Grobfilters (COF) erzeugt, die angibt, ob der Messwert $x_p$ oberhalb oder unterhalb des Referenzwerts $x_i$ liegt, und wobei der Feinfilter (FIF) die m hinteren Bits des vom Subtrahierer (41) erzeugten Differenzwert ($x_p$-$x_i$) betrachtet, wobei der Feinfilter (FIF) so ausgebildet ist, dass er eine insbesondere 1-bitwertige Messantwort (D) an einem Ausgang des Feinfilters (FIF) erzeugt, die angibt, ob der Messwert $x_p$ das Toleranzkriterium

$$(x_p - x_i) = \Delta x_q$$

oder das Tolerarzkriterium

$$\left| x_p - x_i \right| \leq \Delta x_i$$

erfüllt, wobei $\Delta x_i$ ein weiterer Toleranzwert ist.

**2.** Elektrische Toleranzanalyseschaltung zur Toleranzanalyse von digitalen und digitalisierten Messwerten mit den folgenden Merkmalen:

- ein erster Eingang zum Empfang eines n-bit-wertigen Messwerts $x_p$,
- ein zweiter Eingang zum Empfang eines n-bit-wertigen
- ein dritter Eingang zum Empfang eines (m+1)-bitwertigen Toleranzwerts $\Delta x_q$,
- eine Überprufungseinrichtung (42, 43) zum Überprüfen des Messwerts $x_p$ anhand wenigstens eines vorgebbaren Toleranzkriteriums,

eine Ausgabeeinrichtung zur Ausgabe eines Ausgangswerts ($x_a$), der sich aus dem Zustand der Überprüfungseinrichtung (42, 43) ergibt, und zwar in Abhängigkeit davon, ob der Messwert $x_p$ das jeweils vorgegebene Toleranzkriterium erfüllt oder nicht;
wobei, die Überprüfungseinrichtung (42, 43) einen Komplementaddierer (43) sowie einen mit dem Komplementaddierer (43) verbundenen Toleranzfilter (42) aufweist,
wobei der Komplementaddierer (43) den ersten Eingang zum Empfang des Messwerts $x_p$ und den zeiter. Eingang zum Empfang und Invertieren des Refererzwerts $x_i$ aufweist, wobei der Komplementaddierer (43) so ausgebildet ist, dass
ein insbesondere (n+1)-bit-wertiger Additionswert ($x_p$+$\bar{x}_i$) aus dem Messwert $x_p$ und aus dem Einserkomplement ($\bar{x}_i$)
oder aus dem Zweierkomplement des Referenzwerts $x_i$ an einem Ausgang des Komplementaddierers (43) erzeugt wird, wobei der Toleranzfilter (42) den dritten Eingang zum Empfang des Toleranzwerts $\Delta x_q$ und einen weiteren mit dem Ausgang des Komplementaddierers (43) verbundenen vierten Eingang aufweist und wobei der Toleranzfilter (42) so ausgebildet

ist dass der Ausgangswert ($x_a$) unter Verwendung des Tolerantwerts $\Delta x_q$ und des vom Komplementaddierer (43) bereitgestellten Additionswerts ($x_p$+ $\bar{x}_i$) erzeugt wird;
wobei der Toleranzfilter (42) einen Grobfilter (COF), einen Feinfilter(FIF) und ein Merkerregister (FLR) aufweist;
der Grobfilter (COF) die (n+1-m) vorderen Bits des vom Komplementaddierer (43) erzeugten Additionswerts ($x_p$+$\bar{x}_i$) verarbeitet, und der Grobfilter (COF) so ausgebildet ist, dass eine Ausgabe an einem Ausgang des Girdofilters (COF) erzeugt wird, die angibt, ob der Messwert $x_p$ oberhalb oder unterhalb des Referenzwerts $x_i$ liegt;
und wobei der Feinfilter (FIF) die m hinterem Bits des vom Komplementaddierer (43) erzeugen Additionswerts ($x_p$+$\bar{x}_i$) betrachtet, wobei der Feinfilter (FIF) so ausgebildet ist,
dass eine insbesondere 1-bit-wertige Messantwort (D) an einem Ausgang des Feinfilters (FIF) erzeugt wird, die angibt, ob der Messwert $x_p$ das Toleranzkriterium

$$(x_p - x_i) = \Delta x_q$$

oder das Toleranzkriterium

$$|x_p - x_i| \leq \Delta x_i$$

erfüllt, wobei $\Delta x_i$ ein weiterer Toleranzwert ist.

**3.** Elektrische Toleranzanalyseschaltung nach einem der Ansprüche 1 oder 2, **dadurch gekennzeichnet, dass** die elektrische Toleranzanalyseschaltung (4), insbesondere der Toleranzfilter (42), einen fünften Eingang zum Empfang einer Modusauswahlvariable (Set) aufweist, wobei abhängig von dem Wert der Modusauswahlvariablen (Set) die Überprüfung des Messwerts ($x_P$) mittels das Toleranzkriteriums

$$(x_p - x_i) = \Delta x_q$$

oder mittels des Toleranzkriteriums

$$|x_p - x_i| \leq \Delta x_i$$

erfolgt.

**4.** Elektrische Toleranzanalyseschaltung nach Anspruch 3,

- **dadurch gekennzeichnet, dass** ein Eingang des Grobfilters (COF) nit dem Ausgang des Subtrahierers (41) bzw. des Komplementaddierers (43) verbunden ist und
- ein erster Eingang des Feinfilters (FIF) mit dem Ausgang des Subtrahierers (41) bzw. des Komplementaddierers (43) verbunden ist und ein zweiter Eingang des Feinfilters (FIF) mit dem Ausgang des Grobfilters (COF) verbunden ist und
- ein dritter Eingang des Feinfilters (FIF) mit einer ersten Datenleitung zum Empfang des Toleranzwerts $\Delta x_q$ verbunden ist und
- dass ein Eingang des Merkerregisters (FLR) mit dem Ausgang des Feinfilters (FIF) verbunden ist und
- dass ein Ausgang des Merkerregisters (FLR) zur Ausgabe das Ausgangswerts ($x_b$) ausgebildet ist und/oder
- ein vierter Eingang des Feinfilters (FIF) mit einer zweiten Datenleitung zum Empfang der Modusauswahlvariablen verbunden ist und/oder (Set) verbunden ist und/oder
- ein weiterer Eingang des Merkerregisters (FLR) mit einer dritten Datenleitung zum Empfang der Medusauswahlvariablen (Set) verbunden ist.

**5.** Elektrische Toleranzanalyseschaltung nach einem der Ansprüche 1 bis 4, **dadurch gekennzeichnet, dass** das Merkerregister (FLR) drei NAND-Gatter (61-63) und ein Oder-Gatter (64) aufweist.

**6.** Elektrische Toleranzanalyseschaltung nach einem der Ansprüche 1 bis 5, **dadurch gekennzeichnet, dass** in einem Produktionstesmodus ein einmaliges Nichterfüllen des Toleranzkryteriums speicherbar ist.

**7.** Elektrische Toleranzanalyseschaltung nach einem der Ansprüche 1 bis 5, wobei der Grobfilter (COF) ein NOR-Gatter (51) und ein NAND-Gatter (52) aufweist.

**8.** Toleranzanalyseanordnung mit den folgenden Merkmalen:

eine elektrische Toleranzanalyseschaltung (4) nach einem der vorhergehenden Anspruche,
- ein Test-Schaltkres (CUT) zum Empfang und zum Verarbeiten von Teststimuli ($x_R$) und zum Erzeugen von Messwerten $x_p$
- eine vierte Datenleitung zum Übertragen der Messwerte $x_p$ die einen Ausgang des Test-Schaltkreises (DUT) mit dem ersten Eingang der elektrischen Toleranzanalyseschaltung (4), verbindet,
- eine Speichereinheit (11),
- eine fünfte Datenleitung zum Übertragen von Referenzwerten $x_i$ und von Toleranzwerten $\Delta x_q$, die wenigstens einen Ausgang der Speichereinheit (11) mit wenigstens dem zweiten und dritten Eingang der elektrischen Toleranzanalyseschaltung (4) und mit dem Feinfilter (FIF) verbindet,
- ein Eingang des Test-Schaltkreises (DUT) sowie ein Eingang der Speichereinheit (11) sind zur synchronen Aufnahme von Teststimuli ($x_k$) vorgesehen,
- die Speichereinheit (11) zur Zuordnung je wenigstens eines Referenzwerts $x_i$ und wenigstens eines Toleranzwerts $\Delta x_q$ zu jedem Teststimulus ($x_4$)

**9.** Toleranzanalyseanordnung nach Anspruch 8,
**dadurch gekennzeichnet, dass**
die Speichereinheit (11) ferner einen Zähler (13) umfasst, der durch eine sechste Datenleitung mit der Ausgabeeinrichtung der'elektrischen Toleranzanalyseschaltung (4) verbunden ist, wobei der Zähler (13) so ausgebildet ist, dass Zählerstände zu in der Speichereinheit (11) abgelegten Referanzwenten $x_i$ und Toleranzwerten $\Delta x_q$ in Abhängigkeit von Ausgangswerten ($x_a$) zuordenbar und inkrementierbar sind.

**10.** Toleranzanalyseanordnung nach Anspruch 8 oder 9,
**dadurch gekennzeichnet, dass**
die Speichereinhein (11) eine Referenzwertdatenbank (12) aufweist, wobei die Referenzwertdatenbank (12) so ausgebildet ist, dass sie verschiedenen Teststimuli ($x_k$) jeweils, wenigstens einen Referenzwert $x_i$ und jeweils wenigstens einen Toleranzwert $\Delta x_q$ zuweist.

**11.** Halbleiterchip bzw. IC mit einer elektrischen Toleranzanalyseschaltung nach einem der Ansprüche 1 bis 7.

**12.** Nadelkarte zum Testen von Halbleiterchips bzw. ICs, wobei die Nadelkarte eine elektrische Toleranzanalyseschaltung (4) nach einem der Ansprüche 1-7 aufweist.

**13.** Loadboard zur Aufnahme einer Nadelkarte zum. Testen von Halbleiterchips bzw. ICs und/oder mit einem oder'mehreren Testsockeln zum. Testen von Halbleiterchips bzw. ICs und/oder zum Anschluss eines Handlers an ein Messgerät zum Testen von Halbleiterchips bzw. ICs, wobei das Loadboard eine elektrische Toleranzanalyseschaltung (4) nach einem der Ansprüche 1-7 aufweist.

**14.** Messgerät mit Mess-Sensoren, insbesondere für Ströme und Spannungen und mit Instrumenten zur Erzeugung von digitalen, zur Weiterverarbeitung mit einem mit dem Messgerät Verbundenen Computersystem bestimmten Signalen aus den gemessenden Werten, insbesondere Strömen und Spannungen, wobei das Messgerät eine elektrische Toleranzanalyseschaltung (4) nach einen der Ansprüche 1 bis 7 aufweist.

**15.** Verfahren zur Toleranzanalyse von digitalen und/oder digitalisierten Messwerten, das die folgenden Schritte vorsieht:

a) Verwenden einer Toleranzanalyseanordnung (10; 14) nach dem Anspruch 10,
b) Verwenden eines Teststimulus-Generators,
c) Erzeugen eines digitalen oder digitalisierten Teststimulus ($x_k$) durch den Teststimulus-Generator;
d) Synchrones. Anlegen des erzeugten Teststimulus ($x_k$) an den Test-Schalthreis (DUT) und an die Speichereinheit (11),
e) Erzeugen eines Messwerts $x_p$ durch Verarbeiten des Teststimulus ($x_k$) durch den Test-Schaltkreis (DUT) und Anlegen des erzeugten Messwerts $x_p$ an die elektrische Toleranzanalyseschaltung (4) ,
f) Zuordnen wenigstens eines Referenzwerts $x_i$ und wenigstens eines Toleranzwerts $\Delta x_q$ zu dem Teststimulus ($x_k$) durch die Referenzwertdatenbank (12) der Speichereinheit (11) und Anlegen des Toleranzwerts $\Delta x_q$ und des Referenzwerts $x_i$ an die elektrische Toleranzanalyseschaltung (4),
g) Erzeugen des Ausgangswerts ($x_p$) durch Überprüfen des Messwerts $x_p$ auf das Toleranzkriterium

$$(x_p - x_i) = \Delta x_q$$

oder auf das Toleranzkriterium

$$|x_p - x_i| \leq \Delta x_i$$

durch die Überprüfungseinrichtung (41, 42; 42, 43), h) Bereitstellen des Ausgangswerts ($x_a$) am Ausgang der elektrischen Toleranzanalyseschaltung (4) durch die Auscabeeinrchtung,
wobei nach Schnitt c) der folgende Schritt durchgeführt wird:

c') Vorgeben eines Werts für eine bzw. die Modusauswahlvariable (Set) und Anlegen der Modusauswahlvariablen (Set) an die elektrische Toleranzanalyseschaltung (4), und dass der Schritt g) wie folgt durchgeführt wird;
g') Erzeugen eines Ausgangswerts $x_a$) durch Überprüfen des
Messwerts $x_p$ durch die elektrische Toleranzanalyseschaltung (4) auf das Toleranzkriterium

$$(x_p - x_i) = \Delta x_q ,$$

falls die Modusauswahlvariable (Set) einen vorgebbaren Wert zur Auswahl eines Diagnosemodus annimmt oder auf das Toleranzkriterium

$$|x_p - x_i| \leq \Delta x_i ,$$

falls die Modusauswahlvariable (Set) einen vorgebbaren Wert zur Auswahl eines Produktionstestmodus annimmt.

**16.** Verfahren zur Toleranzanalyse nach Anspruch 15, **dadurch gekennzeichnet, dass** nach Schritt g') der folgende Schritt durchgeführt wird:

g') Zuleiten des Ausgangswerts ($x_a$) an einen bzw. den Zähler (13) durch die Ausgabeeinrichtung, Zuordner des Ausgangswerts ($x_a$) zu einem Zählerwert des jeweils betrachteten Referenzwerts $x_i$ und des jeweils betrachteten Toleranzwerts $\Delta x_q$ und Inkrementieren dieses zählerwerts um den Betrag des Ausgangswerts ($x_a$).

## Claims

**1.** Electric tolerance analysis circuit for tolerance analysis for digital and digitized measured values with the following features:

- a first input for receiving an n-bit measured value $x_p$,
- a second input for receiving an n-bit reference value $x_i$,
- a third input for receiving an (m+1)-bit tolerance value $\Delta x_q$,
- a checking device (41, 42) for checking the measured value $x_p$ using at least one prescribable tolerance criterion,
- an output device for outputting an output value ($x_a$) which is obtained from the state of the checking device (41, 42), specifically depending on whether or not the measured value $x_p$ meets the respectively prescribed tolerance criterion,

where the checking device (41, 42) has a subtractor (41) and a tolerance filter (42) connected to the subtractor (41), where, the subtractor (41) has the first input for receiving the measured value $x_p$ and the second input for receiving the reference value ($x_i$), where the subtractor (41) is designed such that a differential value ($x_p$ - $x_i$) is produced from the measured value $x_p$ and from the reference value $x_i$ at an output of the subtractor (41),
where the tolerance filter (42) has the third input for receiving the tolerance value $\Delta x_q$ and a further fourth input connected to the output of the (41),
and where the tolerance filter (42) is designed such, that the output value ($x_a$) is produced using the tolerance value $\Delta x_q$ and the differential value ($x_p$ - $x_i$) provided by the subtractor (41),
where the tolerance filter (42) has a coarse filter (COF), a fine filter (FIF) and a flag register (FLR),

and the coarse filter (COF) processes the (n+1-m) front bits of the differential value ($x_p$-$x_i$) produced by the subtractor (41),
the coarse filter (COF) being designed such that it producers an output, at an output of the coarse filter (COF), which indicates whether the measured value $x_p$ is above or below the reference value, $x_i$, and where the fine filter (FIF) looks at the m back bits of the differential value ($x_p$-$x_i$) produced by the subtractor (41), the fine filter (FIF) being designed such that, at an output of the fine filter (FIF), a particularly 1-bit measurement response (D) which indicates whether the measured value $x_p$ meets the tolerance criterion

$$(x_p - x_i) = \Delta x_q$$

or the tolerance criterion

$$|x_p - x_i| \leq \Delta x_i$$

Δx being a further tolerance value.

**2.** Electric tolerance analysis circuit for tolerance analysis for digital and digitized measured values with the following features:

- a first input for receiving an n-bit measured value $x_p$,
- a second input for receiving an n-bit reference value $x_i$,
- a third input for receiving an (m+1)-bit tolerance value $\Delta x_q$,
- a checking device (42, 43) for checking the measured value $x_p$ using at least one prescribable tolerance criterion,
- an output device for outputting an output value ($x_a$) which is obtained from the state of the checking device (42, 43), specifically depending on whether or not the measured value $x_p$ meets the respectively prescribed tolerance criterion;

where the checking device (42, 43) has a complement adder (43) and also a tolerance filter (42) connected to the complement adder (43),
where the complement adder (43) has the first input for receiving the measured value $x_p$ and the second input for receiving and inverting the reference value $x_i$,
where the complement adder (43) is designed such that a particularly (n+1)-bit addition value ($x_p + \overline{x_i}$), is produced at an output of the complement adder (43) from the measured value $x_p$ and from the ones complement ($\overline{x_i}$) or from the twos complement of the reference value ($x_i$), where the tolerance filter (42) has the third input for receiving the tolerance value $\Delta x_q$ and a further fourth input connected to the output of the complement adder (43), and where the tolerance filter (42) is designed such that the output value (a) is produced using the tolerance value $\Delta x_q$ and the addition value ($x_p + \overline{x}_i$) provided by the complement adder (43);
where the tolerance filter (42) has a coarse filter (COF), a fine filter (FIF) and a flag register (FLR);
where the coarse filter (COF) processes the (n+1-m), front bits of the addition value ($x_p + \overline{x}_i$) produced by the complement adder (43), and the coarse filter (COF) is designed such that it produces an output, at an output of the coarse filter (GOF), which indicates whether the measured value $x_p$ *is* above or below the reference value $x_i$; and where the fine filter (FIF) looks at the m back bits of the addition value ($x_p + \overline{x}_i$) produced by the complement adder (43), the fine filter (FIF) being designed such that it produces a particularly 1-bit measurement response (D), at an output of the fine filter (FIF), which indicates whether the measured value $x_P$ meets the tolerance criterion

$$(x_p - x_i) = \Delta x_q$$

or the tolerance criterion

$$|x_p - x_i| \leq \Delta x_i$$

Δx being a further tolerance value.

**3.** Electric tolerance analysis circuit according to one of claims 1 or 2,
**characterized in that**
the electric tolerance analysis circuit (4), particularly the tolerance filter (42), has a fifth input for receiving a mode selection variable (Set),
where depending on the value of the mode selection variable (Set) the measured value ($x_p$) is checked using the tolerance criterion

$$(x_p - x_i) = \Delta x_q$$

or using the tolerance criterion

$$|x_p - x_i| \leq \Delta x_i.$$

**4.** Electric tolerance analysis circuit according to Claim 3,
**characterized in that**

- an input of the coarse filter (COF) is connected to the output of the subtractor (41) or of the complement adder (43), and
- a first input of the fine filter (FIF) is connected to the output of the subtractor (41) or of the complement adder (43), and
- a second input of the fine filters (FIF) is connected to the output of the coarse filter (COF), and
- a third input of the fine filter (FIF) is connected to a first data line for receiving the tolerance value $\Delta x_q$, and
- **in that** as input of the flag register (FLR) is connected to the output of the fine filter (FIF) and
- **in that** an output of the flag register (FLR) is designed for outputting the output value ($x_a$), and/or
- a fourth input of the fine filter (FIF) is connected to a second data line for receiving the mode selection variable (Set), and/or
- a further input of the flag register (FLR) is connected to a third data line for receiving the mode selection variable (Set).

**5.** Electric tolerance analysis circuit according to one of Claims 1 to 4,
**characterized in that**
the flag register (FLR) has three NAND gates (61-63) and an OR gate (64).

**6.** Electric tolerance analysis circuit according to one of Claims 1 to 5,
**characterized in that**
in the production test mode a single failure to meet the tolerance criterion can be stored,

**7.** Electric tolerance analysis circuit according to one of Claims 1 to 5, where the coarse filter (COF) has a NOR gate (51) and a NAND gate (52).

**8.** Tolerance analysis circuit with the following features:

- an electric tolerance analysis circuit (4) according to one of the preceding claims,
- a test circuit (DUT) for receiving and processing test stimuli ($x_k$) and for producing measured values $x_p$,
- a fourth data line for transmitting the measured values of which connects an output of the test circuit (DUT) to the first input of the electric tolerance analysis circuit (4)
- a memory unit (11),
- a fifth data line for transmitting reference values $x_i$ and tolerance values $\Delta x_q$ which connects at least one output of the memory unit (11) to at least the second and third input of the electric tolerance analysis circuit (4) and to the fine filter (FIF),
- an input of the test circuit (DUT) and also an input of the memory unit (11) are provided for synchronously receiving test stimuli ($x_k$),
- the memory unit (11) for the association of at least one reference value $x_i$ and at least one tolerance value $\Delta x_q$ with each test stimulus ($x_k$).

**9.** Tolerance analysis circuit according to Claim 8, **characterized in that** the memory unit (11) also comprises a counter (13) which, is, connected by a sixth data line to the output, device of the electric tolerance analysis circuit (4), the counter (13) being designed such that counter readings can be associated with reference values $x_i$ and tolerance values $\Delta x_q$ stored in the memory unit (11), and can be incremented, on the basis of output values ($x_a$).

**10.** Tolerance analysis arrangement according to claim 8 or 9, **characterized in that** the unit (11) has a reference value database (12), with the reference value database (12) being designed such that it associates at least one respective reference value $x_i$ and at least one respective tolerance value $\Delta x_q$ with various test stimuli ($x_k$).

**11.** Semiconductor chip or IC with an electric tolerance analysis circuit according to one of Claims 1-7.

**12.** Needle card for testing semiconductor chips or ICs, where the needle card has an electric tolerance analysis circuit (4) according to one of Claims 1-7.

**13.** Loadboard for holding a needle card for testing semiconductor chips or TCs and/or with one or more test sockets for testing semiconductor chips or ICs and/or for connecting a handler to a measuring appliance for testing semiconductor chips or ICs, where the loadboard has an electric tolerance analysis circuit (4) according to one of Claims 1-7.

**14.** Measuring appliance with measuring sensors, particularly for currents and voltages, and with instruments for producing digital signals, intended for further processing using a computer system connected to the measuring appliance, from the measure values, particularly currents and voltages, where the measuring appliance, has an electric, tolerance analysis circuit (4) according to one of Claims 1-7.

**15.** Method for tolerance analysis for digital and/or digitized measured values which provides the following steps:

a) a tolerance analysis arrangement (10; 14) according to Claim 10 is used,
b) a test stimulus generator is used,
c) a digital or digitized test stimulus ($x_k$) is produced by the test stimulus generator,
d) the test stimulus ($x_k$) produced is synchronously applied to the test circuit (DUT) and to the memory unit (11),
e) a measured value $x_p$ is produced by processing the test stimulus ($x_k$) using the test circuit (DUT) and applying the measured value $x_p$ produced to the electric tolerance analysis circuit (4),
f) at least one reference value $x_i$ and at least one tolerance value $\Delta x_q$ are associated with the test stimulus ($x_k$) by the reference value database (12) cf the memory unit (11) and the tolerance value $\Delta x_q$ and the reference value $x_i$ are applied to the electric tolerance analysis circuit (4),
g) the output value ($x_a$) is produced by virtue of the checking device (41, 42; 42, 43) checking the measured value $x_p$ for the tolerance criterion

$$(x_p - x_i) = \Delta x_q$$

or for the tolerance criterion

$$|x_p - x_i| \leq \Delta x_i,$$

h) the output value ($x_a$) is provided at the output of the electric tolerance analysis circuit (4) where after step c) the following, step is performed:

c') a value is prescribed for a or the mode selection variable (Set) and the mode selection variable (Set) is applied to the electric tolerance analysis circuit (4),
and in that step g) is performed as follows:
g') an output value ($x_d$) is produced by virtue of the electric tolerance analysis circuit (4) checking the

measured value $x_p$ for the tolerance criterion

$$(x_p - x_i) = \Delta x_q$$

if the mode selection variable (Set) assumes a prescribable value for selecting a diagnosis mode, or for the tolerance criterion

$$|x_p - x_i| \leq \Delta x_i$$

if the mode selection variable (Set) assumes a prescribable value for selecting a production test mode.

**16.** Method for tolerance analysis according to Claim
**characterized in that**
after step g') the following step is performed:

g'') the output value ($x_a$) is routed to a or the counter (13) by the output device, the output value ($x_a$) is associated with a counter value for the respective reference value $x_i$ being considered and for the respective tolerance value $\Delta x_q$ being considered, and this counter value is incremented by the absolute value of the output value ($x_a$).

## Revendications

**1.** Circuit électrique d'analyse de tolérance pour l'analyse de tolérance de valeurs de mesure numériques et numérisées ayant les caractéristiques suivantes :

- une première entrée pour la réception d'une valeur $x_p$ de mesure d'un poids de n bits,
- une deuxième entrée pour la réception d'une valeur $x_i$ de référence d'un poids de n bits,
- une troisième entrée pour la réception d'une valeur $\Delta x_4$ de tolérance d'un poids de (m+1) bits,
- un dispositif (41, 42) pour le contrôle de la valeur $x_p$ de mesure à l'aide d'au moins un critère de tolérance pouvant être prescrit, un dispositif de sortie pour la sortie d'une valeur $x_a$ de sortie, qui provient de l'état du dispositif (41, 42) de contrôle et de fait en fonction du point de savoir si la valeur $x_p$ de mesure satisfait le critère de tolérance prescrit respectivement ou ne le satisfait pas, dans lequel le dispositif (41, 42) de contrôle comprend un

soustracteur (41) ainsi qu'un filtre (42) de tolérance relié au soustracteur (41),
dans lequel le soustracteur (41) comprend la' première entrée pour la réception de la valeur $x_p$ de mesure et la deuxième entrée pour la réception de la valeur $x_i$ de référence,
dans lequel le soustracteur (41) est tel qu'il produit sur une sortie du soustracteur (41) une valeur ($x_p$-$x_i$) de différence à partir de la valeur $x_p$ de mesure et de la valeur $x_i$ de réference,
dans lequel le filtre (42) de tolérance comprend la troisième entrée pour la réception de la valeur $\Delta x_q$ de tolérance et une autre quatrième entrée reliée à la sortie du soustracteur (41) et dans lequel le filtre (42) de tolérance est tel que la valeur ($x_a$) de sortie est produite en utilisant la valeur $\Delta x_q$ de tolérance et la valeur ($x_p$-$x_i$) de différence procurée par le soustracteur (41),
dans lequel le filtre (42) de tolérance comporte un filtre (COF) grossier, un filtre (FIF) fin et un registre (FLR) indicateur ;
et le filtre grossier traite les (n+1-m) bits avant de la valeur ($x_p$-$x_i$) de différence produite par le soustracteur (41), dans lequel le filtre (COF) grossier est tel qu'il produit sur une sortie du filtre (COF) grossier une sortie qui indique si la valeur $x_p$ de mesure est supérieure ou inférieure à la valeur $x_i$ de référence,
et dans lequel le filtre (FIF) fin considère les m bits arrières de la valeur ($x_p$-$x_i$) de différence produite par le soustracteur (41), le filtre (FIF) fin étant tel qu'il produit sur une sortie du filtre (FIF) fin une réponse (D) mesure d'un poids, notamment de 1 bit, qui indique si la valeur $x_p$ de mesure satisfait le critère de tolérance

$$(x_p - x_i) = \Delta x_q$$

ou le critère de tolérance

$$|x_p - x_i| \leq \Delta x_i$$

$\Delta x_i$ étant une autre valeur de tolérance.

**2.** Circuit électriqne d'analyse de tolérance pour l'analyse de tolérance de valeurs de mesure numériques et numérisées ayant les caractéristiques suivantes ;

- une première entrée pour la réception d'une valeur $x_p$ de mesure d'un poids de n bits,
- une deuxième entrée pour la réception d'une valeur $x_i$ de référence d'un poids de n bits,
- une troisième entrée pour la réception d'une valeur $\Delta x_q$ de tolérance d'un poids de (m+1) bits,
- un dispositif (42, 43) de contrôle de la valeur $x_p$ de mesure à l'aide d'au moins un critère de tolérance pouvant être prescrit,
- un dispositif de sortie pour la sortie d'une valeur ($x_a$) de sortie, qui provient de l'état du dispositif (42, 43) de contrôle et de fait en fonction du point de savoir si la valeur $x_p$ de mesure satisfait le critère de tolérance prescrit respectivement ou ne le satisfait pas,

dans lequel le dispositif (42, 43) de contrôle comprend un additionneur (43) de complément ainsi qu'un filtre (42) de tolérance relié à l'additionneur (43) de complément, dans lequel l'additionneur (43) de complément comprend la première entrée pour la réception et l'inversion de la valeur $x_p$ de mesure et la deuxième entrée pour la réception de la valeur $x_i$ de référence, l'additionneur (43) de complément étant tel qu'il produit à une sortie de additionneur, (43) de complément une valeur ($x_p+\overline{x}_i$) d'addition, notamment d'un poids de (n+1) bits à partir de la valeur $x_p$ de mesure et du complément ($\overline{x}_i$) à 1 ou à partir du complément à 2 de la valeur $x_i$ de référence, le filtre (42) de tolérance comprenant la troisiéme entrée pour la réception de la valeur $\Delta x_q$ de tolérance et une autre quatrième entrée reliée à la sortie de l'additionneur (43) de complément et le filtre (42) de tolérance étant tel qu'il produit la valeur ($x_a$) de sortie en utilisant la valeur $\Delta x_q$ tolérance et la valeur ($x_p+\overline{x}_i$) d'addition procurée par l'additionneur (43) de complément ;

dans lequel le filtre de tolérance comprend un filtre (COF) grossier, un filtre (FIF) fin et un registre (FLR) indicateur ;

dans lequel le filtre (COF) grossier traite les (n+1-m) bits avant de la valeur ($x_p+\overline{x}_i$) d'addition produite par l'additionneur (43) de complément et le filtre (COF) grossier est tel qu'il produit sur une sortie du filtre (COF) grossier une sortie qui indique si la valeur $x_p$ de mesure est supérieure ou inférieure à la valeur $x_i$ de référence ;

et dans lequel le filtre (FIF) fin considère les m bits arrières de la valeur ($x_p+\overline{x}_i$) d'addition produite par l'additionneur (43) de complément, le filtre (FIE) fin étant tel qu'il produit sur une sortie du filtre (FIF) fin une réponse (D) de mesure, notamment d'un poids de 1 bit, qui indique si la valeur $x_p$ de mesure satisfait le critère de tolérance

$$(x_p - x_i) = \Delta x_q$$

ou le critère de tolérance

$$|x_p - x_i| \leq \Delta x_i$$

$\Delta x_i$ étant une autre valeur de tolérance.

**3.** Circuit électrique d'analyse de tolérance suivant l'une des revendications 1 ou 2,
**caractérisé en ce que**
le circuit (4) électrique d'analyse de tolérance, notamment le filtre (42) de tolérance, comprend une cinquième entrée pour la réception d'une variable (Set) de sélection de mode, dans lequel, en fonction de la valeur de la variable (Set) de sélection de mode, le contrôle de la valeur ($x_p$) de mesure s'effectue, au moyen du critère de tolérance

$$(x_p - x_i) = \Delta x_q$$

ou au moyen du critère de tolérance

$$|x_p - x_i| \leq \Delta x_i .$$

**4.** Circuit électrique d'analyse de tolérance suivant la revendication 3, **caractérisé en ce que**

- une entrée du filtre (COF) grossier est reliée à la sortie du soustracteur (41) ou de l'additionneur (43) de complément et
- une première entrée du filtre (FIF) fin est reliée à la sortie du soustracteur (41) ou de l'additionneur (43) de complément et
- une deuxième entrée du filtre (FIF) fin est reliée à la sortie du filtre (COF) grossier et
- une troisième entrée du filtre (FIF) fin est reliée à une première ligne de données pour la réception de la valeur $\Delta x_q$ de tolérance et
- **en ce qu'**une entrée du registre (FLR) indicateur est réliée à la sortie du filtre (FIF) fin et
- **en ce qu'**une sortie du registre (FLR) indicateur est constituée pour la sortie de la valeur ($x_a$) de sortie et/ou
- Une quatrième entrée du filtre (FIF) fin est reliée à une deuxième ligne de données pour la réception de la mariable (Set) de sélection de mode et/ou
- une autre entrée du registre (FLR) indicateur est reliée à une troisième ligne de données pour la réception de la variable (Set) de sélection de mode.

**5.** Circuit électrique d'analyse de tolérance suivant l'une des revendications 1 à 4, **caractérisé en ce que** le registre (FLR) indicateur comprend trois portes (61 à 63) NON ET et une porte (64) OU.

**6.** Circuit électrique d'analyse de tolérance suivant l'une des revendications 1 à 5, **caractérisé en ce que**, dans un mode de test de production, la non satisfaction une fois du critère de tolérance peut être mémorisée.

**7.** Circuit électrique d'analyse de tolérance suivant l'une des revendications 1 à 5, dans lequel, le filtre (COF) grossier comprend une porte (51) NON OU et une porte (52) NON ET,

**8.** Dispositif d'analyse de tolérance, comprenant les caractéristiques suivantes :

un circuit (4) électrique d'analyse de tolérance suivant l'une des revendications précédentes,
- un circuit (DUT) de test pour la réception et le traitement de stimuli ($x_k$) de test et pour la production de valeurs $x_p$ de mesure,
- une quatrième ligne de données pour la transmission des valeurs $x_p$ de mesure, qui relie une sortie du circuit (DUT) de test à la première entrée du circuit (4) électrique d'analyse de tolérance,
- une unité (11) de mémoire,
- une cinquième, ligne de données pour la transmission des valeurs $x_i$ de référence et de valeurs $\Delta x_q$ de tolérance, qui relie au moins une sortie de l'unité (11) de mémoire à au moins la deuxième et la troisième entrée du circuit (4) électrique d'analyse de tolérance et au filtre (FIF) fin,
- une entrée du circuit (DUT) de test ainsi qu'une entrée de l'unité (11) de mémoire sont prévues pour la réception synchrone de stimuli ($x_k$) de test,
- l'unité (11) de mémoire pour l'affectation de respectivement au moins une valeur $x_i$ de référence et d'au moins une valeur $\Delta x_q$ de tolérance à chaque stimulus ($x_k$) de test.

**9.** Dispositif d'analyse de tolérance suivant la revendication **caractérisé en ce que** l'unité (11) de mémoire comprend, en outre, un compteur (13), qui est relié au dispositif de sortie du circuit (4) électrique d'analyse de tolérance par une sixième ligne de données, le compteur (13) étant tel qu'il peut associer et incrémenter des valeurs $x_i$ de référence et des valeurs $\Delta x_q$ de tolérance en fonction de valeurs ($x_a$) de sortie.

**10.** Dispositif d'analyse de tolérance suivant la revendication 8 ou 9, **caractérisé en ce que** l'unité (11) de mémoire comprend une base (12) de données de référence, la base (12) de données de valeurs de référence étant telle qu'elle affecte respectivement au moins une valeur $x_i$ de référence et respectivement au moins

une valeur $\Delta x_q$ de tolérance aux divers stimuli ($x_k$) de test.

**11.** Puce à semiconducteurs ou CI ayant un circuit électrique d'analyse de tolérance suivant l'une des revendications 1 à 7.

**12.** Carte à aiguille pour tester des puces à semiconducteurs ou des CI, dans laquelle la carte à aiguille a un circuit (4) électrique d'analyse de tolérance suivant l'une des revendications 1 à 7.

**13.** Loadboard pour la réception d'une carte à aiguille pour tester des puces à semiconducteurs ou des CI et/ou comprenant un ou plusieurs culots de test pour tester des puces à semiconducteurs ou des CI et/ou pour le accordement d'un manipulateur à un appareil de mesure pour le test de puces à semiconducteurs ou de CI, le Loadboard comprenant un circuit (4) électrique d'analyse de tolérance suivant l'une des revendications 1 à 7.

**14.** Appareil de mesure ayant des capteurs de mesure, notamment pour des courants et des tensions, et ayant des instruments de production de signaux numériques destinés à être traités ultérieurement par un système informatique relié à l'appareil de mesure, ces signaux étant composés des valeurs mesurées, notamment de courants et de tensions, l'appareil de mesure comprenant un circuit (4) électrique d'analyse de tolérance suivant l'une des revendications 1 à 7.

**15.** Procédé d'analyse de tolérance de valeurs de mesure numériques a et/ou numérisées, qui prévoit les stades suivants :

a) utilisation d'un dispositif (10, 14) d'analyse de tolérance suivant la revendication 10,
b) utilisation d'un générateur de stimulus de test,
c) production d'un stimulus ($x_k$) de test numérique ou numérisé par le générateur de stimulus de test,
d) application synchrone du stimulus ($x_k$) de test produit au circuit (DUT) de test et à l'unité (11) de mémoire,
e) production d'une valeur $x_p$ de mesure par traitement du stimulus ($x_k$) de test par le circuit (DUT) de test et application de la valeur $x_p$ de mesure produite au circuit (4) électrique d'analyse de tolérance,
f) affectation d'au moins une valeur $x_i$ de référence et d'au moins une valeur $\Delta x_q$ de tolérance au stimulus ($x_k$) de test par la base (12) de données de valeurs de préférence de l'unité (11) de mémoire et application de la valeur $\Delta x_q$ de tolérance et de la valeur $x_i$ de référence au circuit (4) électrique d'analyse de tolerance,
g) production de la valeur ($x_a$) de sortie par contrôle de la valeur $x_p$ de mesure sur le critère de tolérance

$$(x_p - x_i) = \Delta x_q$$

ou sur le critère de tolérance

$$|x_p - x_i| \leq \Delta x_i$$

par le dispositif (41, 42 ; 42, 43) de contrôle,
h) mise à disposition de la valeur ($x_a$) de sortie à la sortie du circuit (4) électrique d'analyse de tolérance par le dispositif de sortie,
dans lequel on effectue, après le stade c), le stade suivant :

c') prescription d'une valeur pour une variable ou pour les variables (Set) de sélection de mode et application de la valeur (Set) de sélection de mode au circuit (4) électrique d'analyse de tolérance,
et en' ce qu'on effectue le stade g) de la manière suivante :
g') production d'une valeur ($x_a$) de sortie par contrôle de la valeur $x_p$ de mesure par le circuit (4) électrique d'analyse de tolérance sur le critère de tolérance

$$(x_p - x_i) = \Delta x_q$$

si la variable (Set) de sélection de mode prend une valeur pouvant être prescrite pour la sélection d'un mode de diagnostic ou sur le critère de tolérance

$$|x_p - x_i| \leq \Delta x_i$$

si la variable (Set) de sélection de mode prend une valeur pouvant être prescrite pour la sélection d'un mode de test de production.

**16.** Procédé d'analyse de tolérance suivant la revendication 15, **caractérisé en ce que** après la stade g'), on effectue le stade suivant :

g'') envoi de la valeur ($x_a$) de sortie à un compteur ou au compteur (13) par le dispositif de sortie, affectation de la valeur ($x_a$) de sortie à une valeur de compteur de la valeur $x_i$ de référence considérée respectivement et de la valeur $\Delta x_q$ de tolérance considérée respectivement et incrémentation de cette valeur de compteur du montant de la valeur ($x_a$) de sortie.

FIG 1

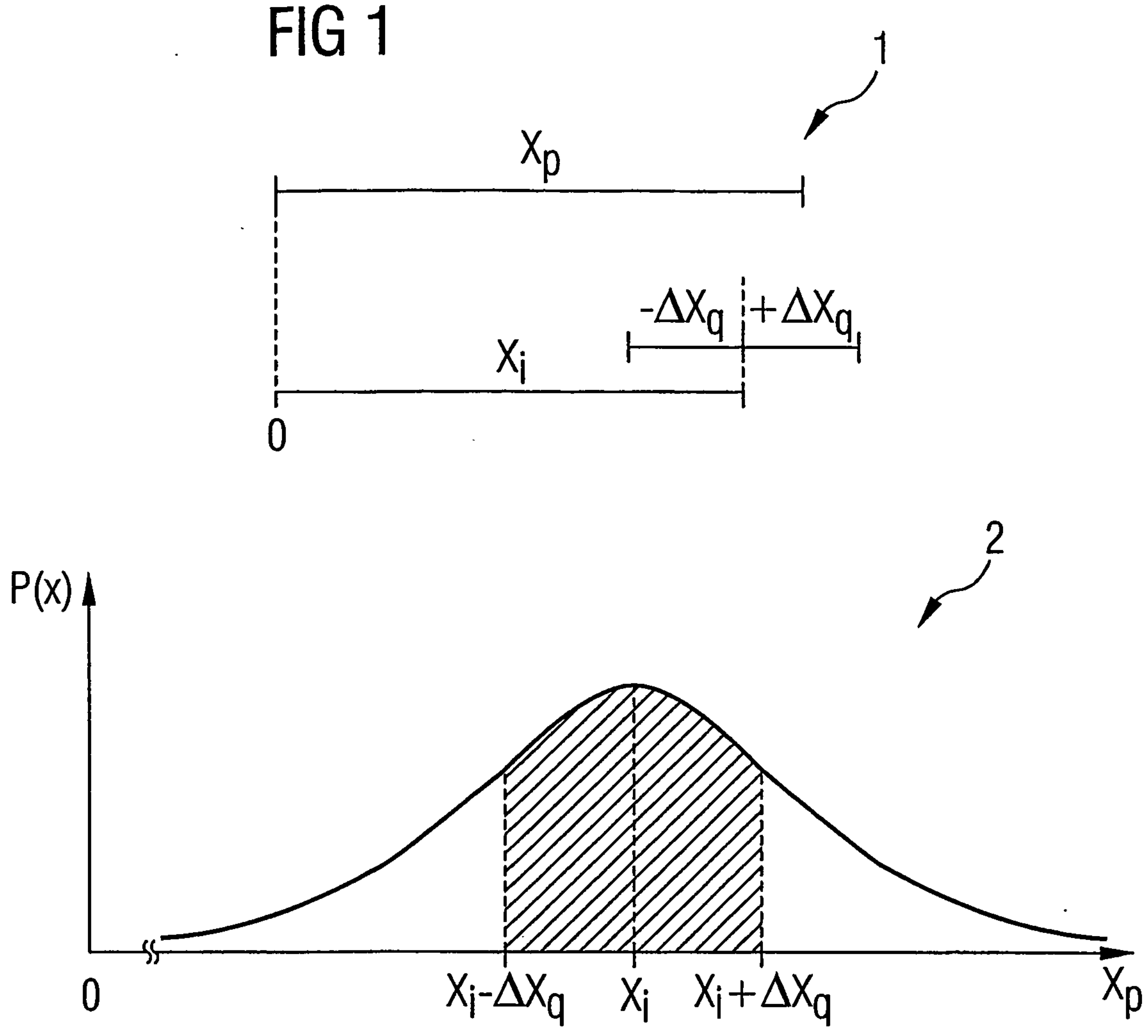

FIG 2

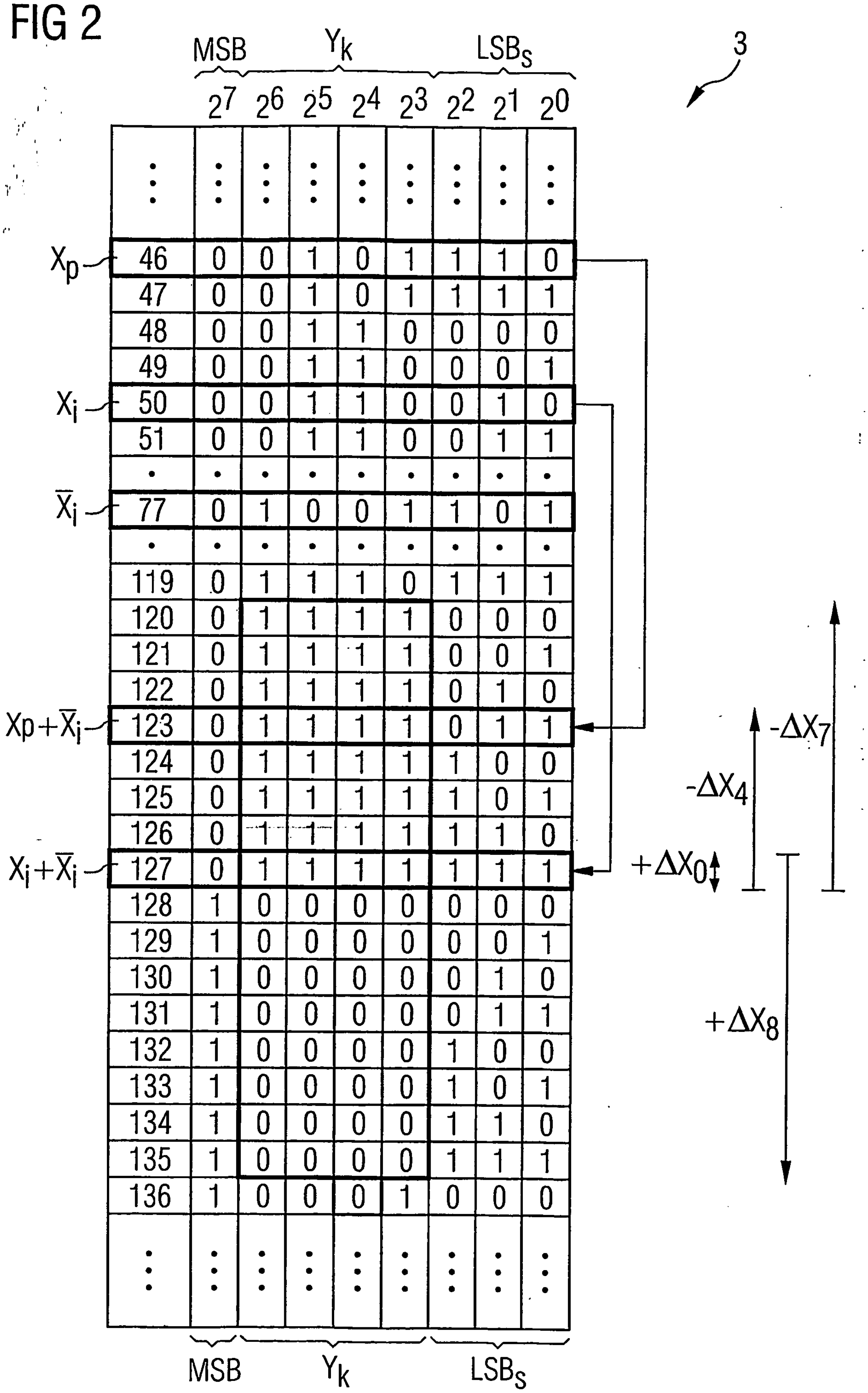
MSB
$Y_k$
$LSB_S$
3
$2^7$ $2^6$ $2^5$ $2^4$ $2^3$ $2^2$ $2^1$ $2^0$
$X_p$ 46 0 0 1 0 1 1 1 0
47 0 0 1 0 1 1 1 1
48 0 0 1 1 0 0 0 0
49 0 0 1 1 0 0 0 1
$X_i$ 50 0 0 1 1 0 0 1 0
51 0 0 1 1 0 0 1 1
$\overline{X}_i$ 77 0 1 0 0 1 1 0 1
119 0 1 1 1 0 1 1 1
120 0 1 1 1 1 0 0 0
121 0 1 1 1 1 0 0 1
122 0 1 1 1 1 0 1 0
$Xp+\overline{X}_i$ 123 0 1 1 1 1 0 1 1
124 0 1 1 1 1 1 0 0
125 0 1 1 1 1 1 0 1
126 0 1 1 1 1 1 1 0
$X_i+\overline{X}_i$ 127 0 1 1 1 1 1 1 1
128 1 0 0 0 0 0 0 0
129 1 0 0 0 0 0 0 1
130 1 0 0 0 0 0 1 0
131 1 0 0 0 0 0 1 1
132 1 0 0 0 0 1 0 0
133 1 0 0 0 0 1 0 1
134 1 0 0 0 0 1 1 0
135 1 0 0 0 0 1 1 1
136 1 0 0 0 1 0 0 0
$-\Delta X_7$
$-\Delta X_4$
$+\Delta X_0$
$+\Delta X_8$
MSB
$Y_k$
$LSB_S$

FIG 3

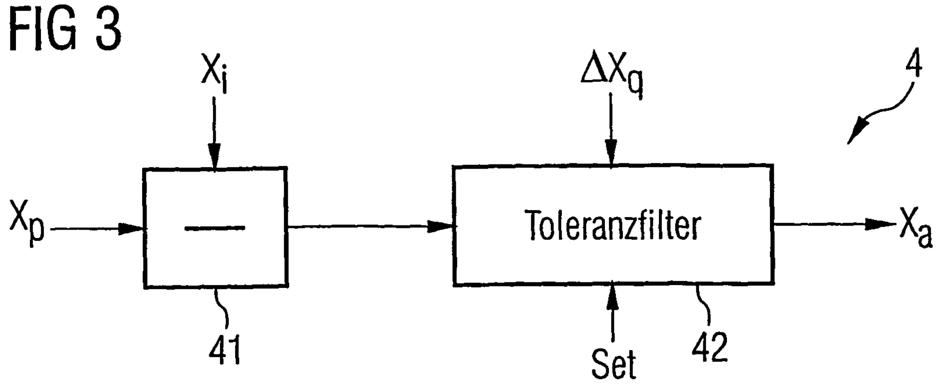


FIG 4

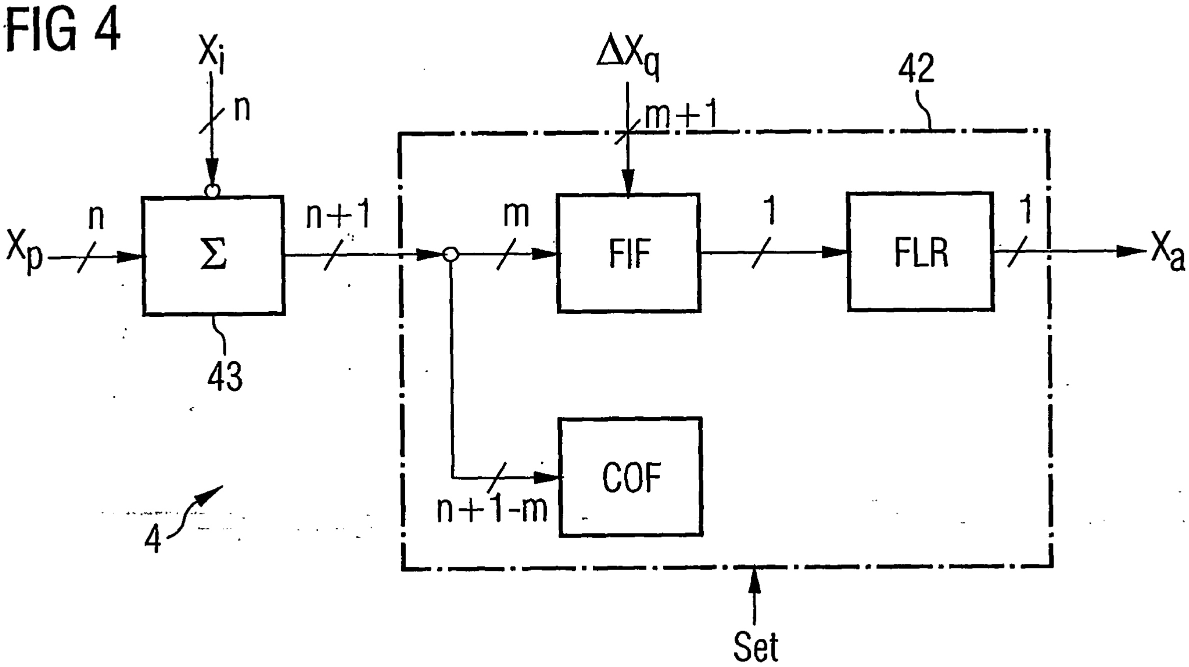


FIG 5

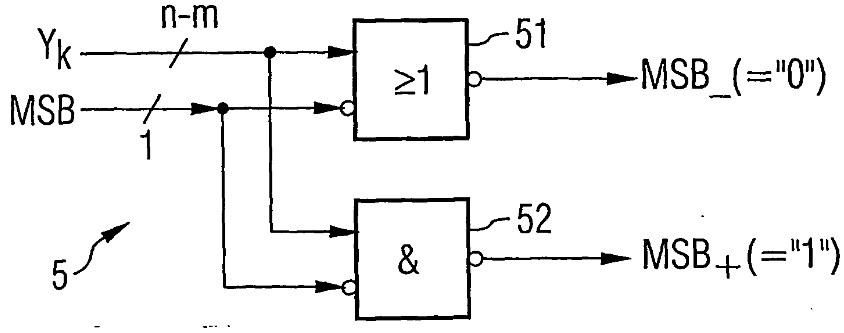

FIG 6

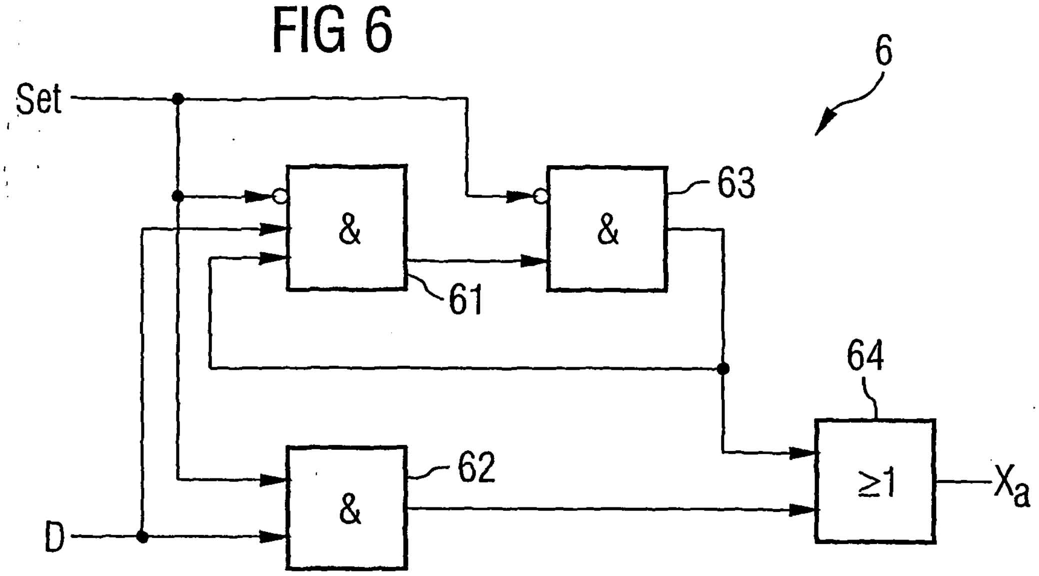


7

| Set | D | $X_a(t-1)$ | $X_a(t)$ | verwendeter Modus |
|---|---|---|---|---|
| 1 | 1 | 1 | 1 | Diagnose-Modus |
| 1 | 1 | 0 | 1 | |
| 1 | 0 | 1 | 0 | keine Speicherung |
| 1 | 0 | 0 | 0 | |
| 0 | 1 | 1 | 1 | Produktions-Modus |
| 0 | 1 | 0 | 0 | Speicherung von 0 |
| 0 | 0 | 1 | 0 | |
| 0 | 0 | 0 | 0 | |

FIG 7

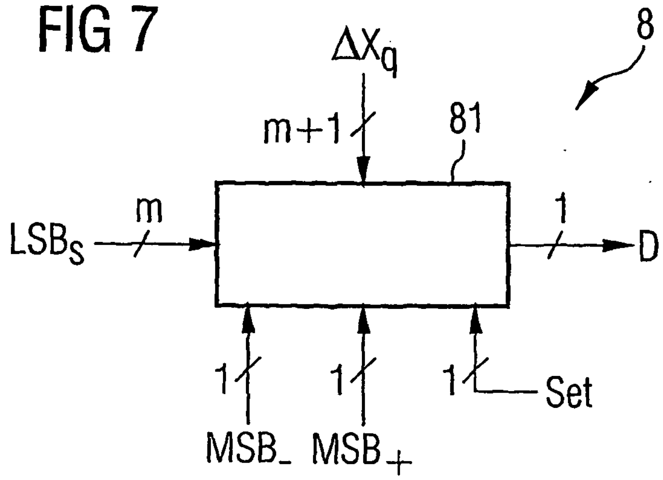

FIG 8

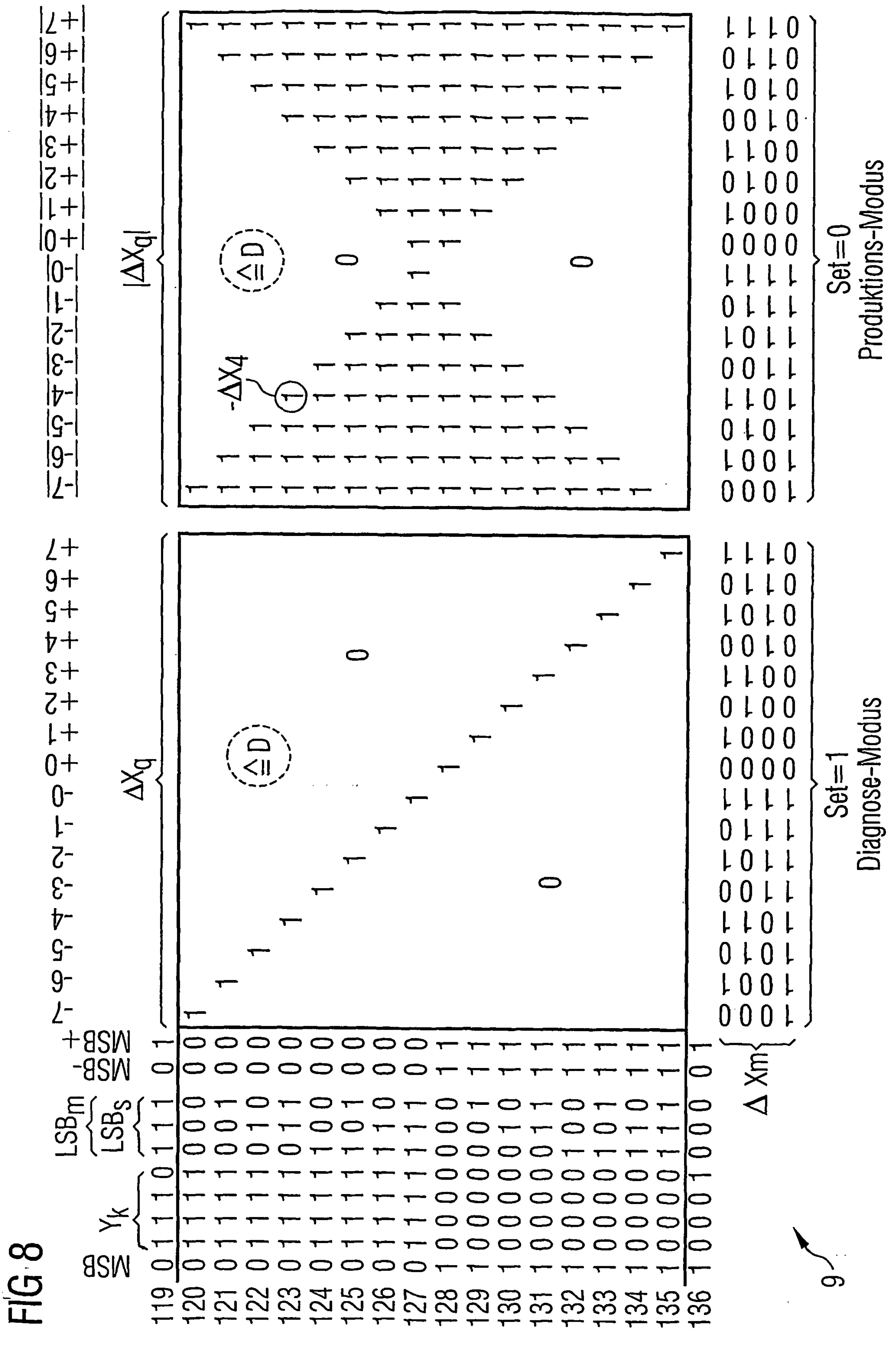
MSB
$Y_K$
$LSB_m$
$LSB_S$
MSB-
MSB+
$\Delta X_q$
$|\Delta X_q|$
$\hat{=}D$
$-\Delta X_4$
$\Delta X_m$
Set=1
Diagnose-Modus
Set=0
Produktions-Modus
9

FIG 9

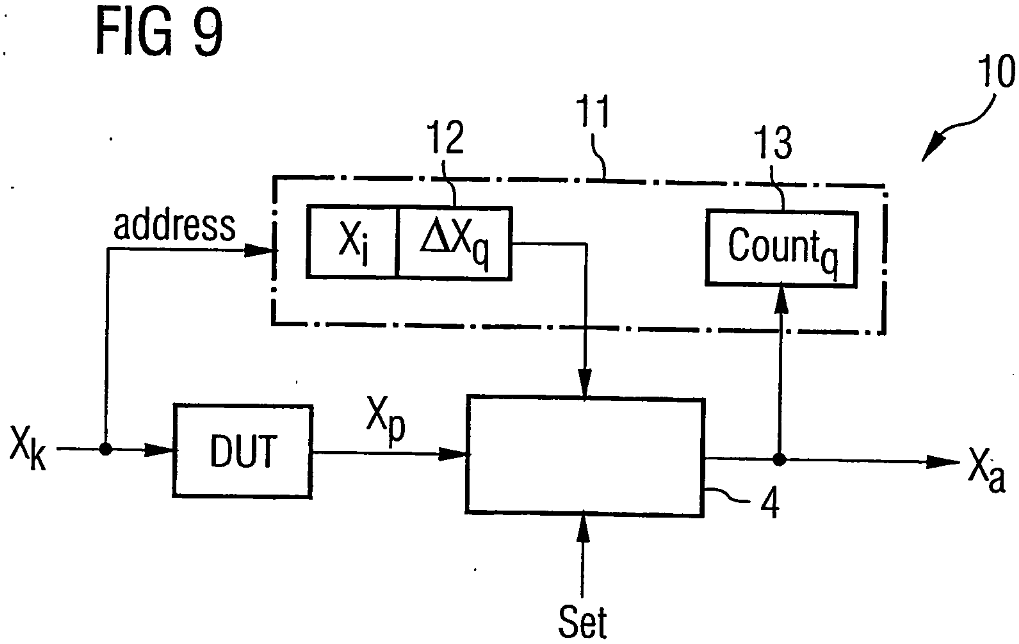
10
11
12
13
address
$X_i$
$\Delta X_q$
$Count_q$
$X_k$
DUT
$X_p$
$X_a$
4
Set

FIG 10

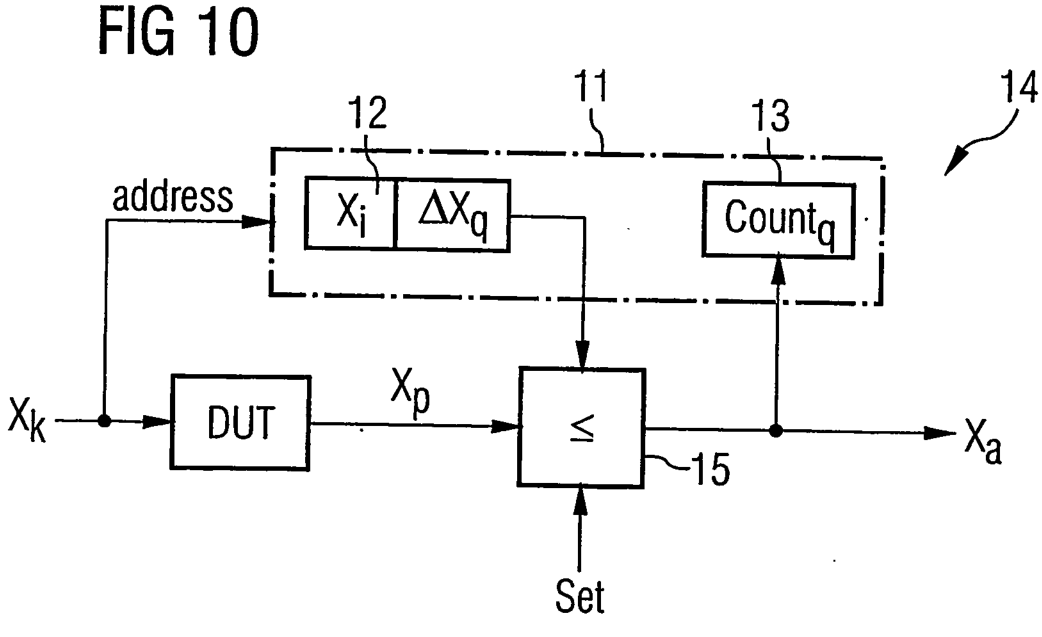
14
11
12
13
address
$X_i$
$\Delta X_q$
$Count_q$
$X_k$
DUT
$X_p$
≤
$X_a$
15
Set

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- JP 56114037 B
- WO 0214883 A